(19) Europäisches Patentamt
European Patent Office
Office européen des brevets

(11) **EP 4 708 675 A1**

(12) **EUROPEAN PATENT APPLICATION**
published in accordance with Art. 153(4) EPC

(43) Date of publication:
**11.03.2026 Bulletin 2026/11**

(21) Application number: **24797271.4**

(22) Date of filing: **08.03.2024**

(51) International Patent Classification (IPC):
**H03F 1/02** (2006.01)   **H03F 1/56** (2006.01)
**H03F 3/21** (2006.01)   **H03F 3/60** (2006.01)

(52) Cooperative Patent Classification (CPC):
**H03F 1/02; H03F 1/56; H03F 3/21; H03F 3/60**

(86) International application number:
**PCT/KR2024/003051**

(87) International publication number:
**WO 2024/225609 (31.10.2024 Gazette 2024/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **27.04.2023 KR 20230055783**

(71) Applicant: **Samsung Electronics Co., Ltd.**
**Suwon-si, Gyeonggi-do 16677 (KR)**

(72) Inventors:
• **KANG, Hyunuk**
  **Suwon-si Gyeonggi-do 16677 (KR)**
• **KIM, Kyoungtae**
  **Suwon-si Gyeonggi-do 16677 (KR)**
• **KIM, Changwook**
  **Suwon-si Gyeonggi-do 16677 (KR)**
• **WOO, Youngyoon**
  **Suwon-si Gyeonggi-do 16677 (KR)**
• **JEE, Seunghoon**
  **Suwon-si Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(54) **DOHERTY POWER AMPLIFIER AND ELECTRONIC DEVICE COMPRISING SAME**

(57)   Provided in embodiments is an electronic device for a Doherty power amplifier. The electronic device may comprise: a coupler for acquiring a radio frequency (RF) input signal; a power amplifier circuit including a carrier amplifier circuit and a peaking amplifier circuit; and a resistor selection circuit for providing isolation impedance from among a plurality of impedances to the coupler.

300

FIG. 3A

EP 4 708 675 A1

## Description

### [Technical Field]

The present disclosure relates to a Doherty power amplifier and an electronic device including the Doherty power amplifier.

### [Background Art]

Products equipped with multiple antennas are being developed to improve communication performance. As the number of antennas increases, the number of RF components (e.g., power amplifier (PA)) for processing signals received or radiated through the antennas also increases.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

According to embodiments, an electronic device for a Doherty power amplifier is provided. The electronic device may comprise a coupler configured to obtain a radio frequency (RF) input signal. The electronic device may comprise power amplifier circuitry including a carrier amplifier circuit and a peaking amplifier circuit. The electronic device may comprise a resistance selection circuit configured to provide, to the coupler, an isolation impedance among a plurality of impedances. A first port of the coupler may be configured to receive the RF input signal. A second port of the coupler may be configured to be connected to the resistance selection circuit. A third port of the coupler may be configured to be connected to the carrier amplifier circuit. A fourth port of the coupler may be configured to be connected to the peaking amplifier circuit. The first port, the second port, the third port, and the fourth port of the coupler may be matched based on a first impedance. The plurality of impedances may include the first impedance and a second impedance smaller than the first impedance.

According to embodiments, an electronic device is provided. The electronic device may comprise a plurality of antenna radiators, a plurality of filters for the plurality of antenna radiators, a plurality of Doherty power amplifier circuits for the plurality of antenna radiators, and a processor. A Doherty power amplifier circuit of the plurality of Doherty power amplifier circuits may comprise a coupler configured to obtain a radio frequency (RF) input signal. The Doherty power amplifier circuit may comprise power amplifier circuitry including a carrier amplifier circuit and a peaking amplifier circuit. The Doherty power amplifier circuit may comprise a resistance selection circuit configured to provide, to the coupler, an isolation impedance among a plurality of impedances. A first port of the coupler may be configured to receive the RF input signal. A second port of the coupler may be configured to be connected to the resistance selection circuit. A third port of the coupler may be configured to be connected to the carrier amplifier circuit. A fourth port of the coupler may be configured to be connected to the peaking amplifier circuit. The first port, the second port, the third port, and the fourth port of the coupler may be matched based on a first impedance. The plurality of impedances may include the first impedance and a second impedance smaller than the first impedance.

### [Description of the Drawings]

FIG. 1 illustrates a wireless communication system.
FIG. 2A illustrates an example of a network entity for a base station.
FIG. 2B illustrates an example of an electronic device including a Doherty power amplifier (PA).
FIG. 2C illustrates another example of an electronic device including a Doherty power amplifier.
FIG. 3A illustrates components of a Doherty power amplifier.
FIG. 3B illustrates an example of power amplifier circuitry of a Doherty power amplifier.
FIG. 4 is a diagram illustrating a principle of a coupler for a Doherty power amplifier.
FIG. 5A illustrates power to a carrier amplifier according to an input capacitance of a peaking amplifier.
FIG. 5B illustrates power to a peaking amplifier according to an input capacitance of a peaking amplifier.
FIG. 6 illustrates an example of power distribution for each isolation resistor.
FIG. 7A illustrates an example of gains for each isolation resistor.
FIG. 7B illustrates an example of drain efficiency (DE) for each isolation resistor.
FIG. 8A illustrates an exemplary circuit of a Doherty power amplifier including a resistor selection circuit.
FIG. 8B illustrates an exemplary circuit of a Doherty power amplifier using a feedback circuit.
FIGS. 9A to 9C illustrate exemplary arrangements of a resistor selection circuit.
FIG. 10 illustrates an example of a functional configuration of an electronic device.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms referring to signals (e.g., signal, information, message, signaling), terms referring to resources (e.g., symbol, slot, subframe, radio frame, subcarrier, resource element (RE), resource block (RB), bandwidth part (BWP), occasion), terms for operation state (e.g., step, operation, procedure), terms referring to data (e.g., packet, user stream, information, bit, symbol, codeword), terms referring to channels, terms referring to network entities, and terms referring to components of a device, used in the following description are exemplified for convenience of explanation. Therefore, the present disclosure is not limited to terms to be described below, and another term having an equivalent technical meaning may be used.

Terms referring to components of an electronic device (e.g., substrate, print circuit board (PCB), flexible PCB (FPCB), module, antenna, antenna element, circuit, amplifier circuit, processor, chip, component, device), terms referring to shapes of components (e.g., structure, structure body, support portion, contact portion, protrusion), terms referring to connections between structures (e.g., connection portion, contact portion, support portion, contact structure, conductive member, assembly), and terms referring to circuits (e.g., PCB, FPCB, signal line, feeding line, data line, RF signal line, antenna line, amplifier circuit, RF path, RF module, RF circuit, splitter, divider, coupler, combiner), used in the following description are exemplified for convenience of explanation. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

Although the present disclosure describes various embodiments using terms used in some communication standards (e.g., 3rd Generation Partnership Project (3GPP), extensible radio access network (xRAN), open-radio access network (O-RAN)), and Institute of Electrical and Electronics Engineers (IEEE)), these are only examples for explanation. The various embodiments of the present disclosure may be easily modified and applied to other communication systems.

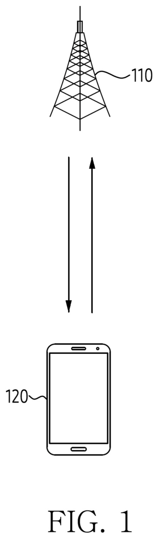

FIG. 1 illustrates a wireless communication system.

Referring to FIG. 1, FIG. 1 illustrates a base station 110 and a terminal 120 as a portion of nodes that utilize a wireless channel in a wireless communication system. FIG. 1 illustrates only one base station, but a wireless communication system may further include another base station that is identical or similar to the base station 110.

The base station 110 is a network infrastructure that provides wireless access to the terminal 120. The base station 110 has coverage defined based on a distance at which a signal may be transmitted. In addition to 'base station', the base station 110 may be referred to as an 'access point (AP)', 'eNodeB (eNB)', '5th generation node', 'next generation nodeB (gNB)', 'wireless point', 'transmission/reception point (TRP)' or other terms having equivalent technical meanings.

The terminal 120, which is a device used by a user, performs communication with the base station 110 through a wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel. At this time, a link (device-to-device link (D2D)) between the terminal 120 and the other terminal is referred to as a sidelink, and the sidelink may be used interchangeably with a PC5 interface. In some other embodiments, the terminal 120 may be operated without the user's involvement. According to an embodiment, the terminal 120, which is a device performing machine type communication (MTC), may not be carried by the user. Additionally, according to an embodiment, the terminal 120 may be a narrowband (NB)-internet of things (IoT) device.

In addition to 'terminal', the terminal 120 may also be referred to as 'user equipment (UE) ', 'customer premises equipment, (CPE) ', 'mobile station', 'subscriber station', 'remote terminal', 'wireless terminal', 'electronic device', 'user device', or other terms having equivalent technical meanings.

The base station 110 may perform beamforming with the terminal 120. The base station 110 and the terminal 120 may transmit and receive a wireless signal in a relatively low frequency band (e.g., frequency range 1 (FR 1) of NR). In addition, the base station 110 and the terminal 120 may transmit and receive a wireless signal in a relatively high frequency band (e.g., FR 2 (or FR 2-1, FR 2-2, FR 2-3) or FR 3), and a mmWave band (e.g., 28GHz, 30GHz, 38GHz, 60GHz). The base station 110 and the terminal 120 may perform beamforming to improve a channel gain. Herein, the beamforming may include transmission beamforming and reception beamforming. The base station 110 and the terminal 120 may provide directivity to a transmission signal or a reception signal. To this end, the base station 110 and the terminal 120 may select serving beams through a beam search or beam management procedure. After the serving beams are selected, subsequent communication may be performed through a resource in a QCL relationship with the resource transmitting the serving beams.

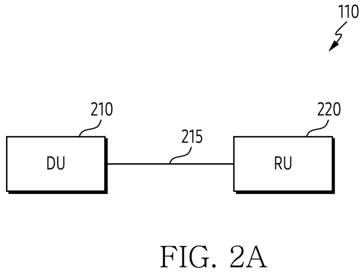

Conventionally, in a communication system with a relatively large cell radius of base station, each base station was installed to include a function of a digital processing unit (or distributed unit (DU)) and a radio frequency (RF) processing unit (or radio unit (RU)). However, as high frequency bands are used in 4th generation (4G) and/or subsequent communication systems (e.g., 5G) and the cell coverage of base stations becomes smaller, the number of base stations to cover a specific area has increased. The burden of installation cost for operators to install base stations has also increased. In order to minimize the installation cost of a base station, a structure in which the DU and RU of the base station are separated, one or more RUs are connected to one DU through a wired network, and one or more Rus geographically distributed to cover a specific area are deployed, has been proposed. Hereinafter, a deployment structure and expansion examples of a base station according to various embodiments of the present disclosure are described through FIG. 2A.

FIG. 2A illustrates an example of a network entity for a base station. For example, a base station may be separated into two or more entities through a fronthaul. Unlike a backhaul between a base station and a core network, the fronthaul refers to an interface between a wireless network and a base station. FIG. 2A illustrates an example of a fronthaul structure between one DU 210 and one RU 220, but this is only for convenience of explanation and the present disclosure is not limited thereto. In other words, the embodiments of the present disclosure may also be applied to a fronthaul structure between one DU and a plurality of RU. For example, the embodiments of the present disclosure may be applied to a fronthaul structure between one DU and two RU. In addition, the embodiments of the present disclosure may also be applied to a fronthaul structure between one DU and three RU.

Referring to FIG. 2A, the base station 110 may include a DU 210 and an RU 220. A fronthaul 215 between the DU 210 and the RU 220 may be operated via an Fx interface. For operation of the fronthaul 215, an interface such as a common public radio interface (CPRI), an enhanced common public radio interface (eCPRI) or radio over ethernet (ROE) may be used.

As communication technology has been developed, mobile data traffic increased, and thus the bandwidth demand required in a fronthaul between a digital unit and a radio unit has increased significantly. In a deployment such as centralized/cloud radio access network (C-RAN), the DU 210 may be implemented to perform functions for packet data convergence protocol (PDCP), radio link control (RLC), media access control (MAC), and physical (PHY), and the RU 220 may be implemented to further perform functions for PHY layer in addition to a radio frequency (RF) function.

The DU 210 may be in charge of upper layer functions of a wireless network. For example, the DU 210 may perform functions of the MAC layer and a part of the PHY layer. Herein, a part of the PHY layer is a function performed at a higher level among the functions of the PHY layer, and may include, for example, channel encoding (or channel decoding), scrambling (or descrambling), modulation (or demodulation), and layer mapping (or layer demapping). According to an embodiment, if the DU 210 complies with an O-RAN standard, it may be referred to as an O-RAN DU (O-DU). The DU 210 may be replaced with and represented as a first network entity for a base station (e.g., gNB) in embodiments of the present disclosure, as needed.

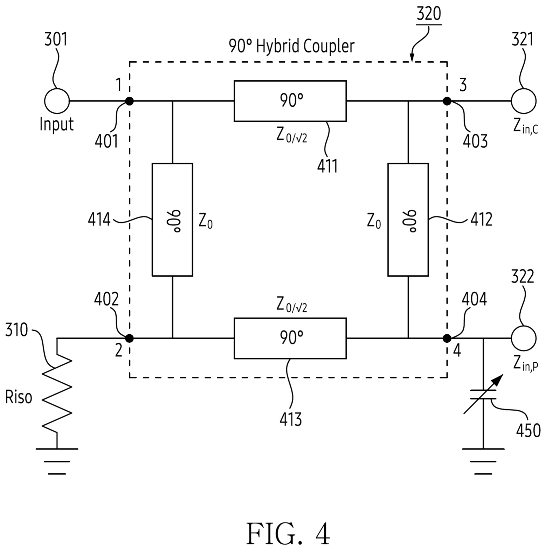

The RU 220 may be in charge of lower layer functions of a wireless network. For example, the RU 220 may perform a part of the PHY layer, and a RF function. Herein, a part of the PHY layer is a function performed at performed at a relatively lower level than the DU 210 among the functions of the PHY layer, and may include, for example, iFFT conversion (or FFT conversion), cyclic prefix (CP) insertion (or CP removal), and digital beamforming. In FIG. 4, an example of such a specific function split is described in detail. The RU 220 may be referred to as access unit (AU), access point (AP), transmission/reception point (TRP), remote radio head (RRH), radio unit (RU), or other terms having equivalent technical meanings. According to an embodiment, if the RU 220 complies with the O-RAN standard, it may be referred to as an O-RAN RU (O-RU). The RU 220 may be replaced with and represented as a second network entity for a base station (e.g., gNB) in embodiments of the present disclosure, as needed.

Although FIG. 2A describes that the base station 110 includes the DU 210 and the RU 220, the embodiments of the present disclosure are not limited thereto. The base station according to the embodiments may be implemented in a distributed deployment according to a centralized unit (CU) configured to perform functions of upper layers (e.g., packet data convergence protocol (PDCP), radio resource control (RRC)) of an access network and a distributed unit (DU) configured to perform functions of lower layers. For example, between a core (e.g., 5G core (5GC) or next generation core (NGC)) network and a radio access network (RAN), the base station may be implemented in a structure in which CU, DU, and RU are arranged in order. In some cases, the expression of a digital unit (DU) is used to explain a relationship between a DU and an RU, but in the present disclosure, a description of a digital unit (DU) may also be understood as a description of a distributed unit (DU). An interface between the CU and the distributed unit (DU) may be referred to as an F1 interface.

A centralized unit (CU) may be in charge of functions of a higher layer than the DU, by being connected to one or more DUs. For example, the CU may be in charge of radio resource control (RRC) and a function of a packet data convergence protocol (PDCP) layer, and the DU and the RU may be in charge of functions of lower layers. The DU may perform radio link control (RLC), media access control (MAC), and some functions (high PHY) of PHY layer, and the RU may perform remaining functions (low PHY) of the PHY layer. In addition, as an example, a digital unit (DU) may be included in a distributed unit (DU) according to the implementation of distributed deployment of the base station. Hereinafter, unless otherwise defined, it is described as operations of the distributed unit (DU) and the RU, but embodiments of the present disclosure may be applied to both of a base station arrangement including the CU or an arrangement where the DU is directly connected to a core network (i.e., the CU and the DU are integrated into a base station (e.g., NG-RAN node) which is a single entity).

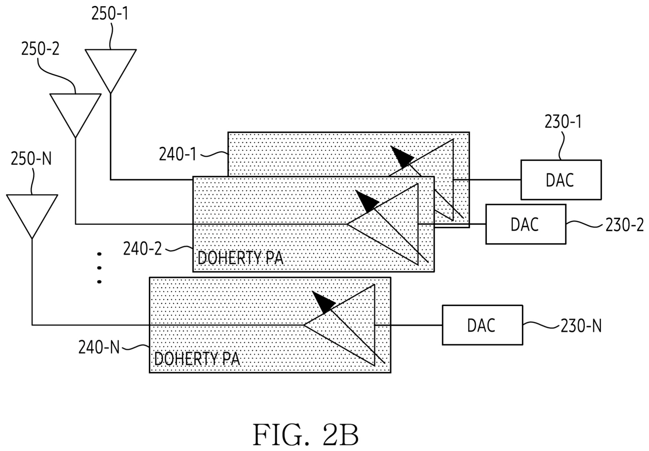

FIG. 2B illustrates an example of an electronic device including a Doherty power amplifier (PA). For example, the electronic device may be a base station 110. For example, the device may be the RU 220.

Referring to FIG. 2B, the electronic device may include a plurality of antennas 250-1, 250-2, ..., and 250-N (where N is an integer equal to or greater than 2). The electronic device may include RF processing circuitry to transmit a wireless signal. In order for signals to be radiated through the plurality of antennas, the RF processing circuitry may include a plurality of RF paths. The electronic device may include an up converter configured to upconvert a digital transmission signal of a baseband to a transmission frequency, and a digital-to-analog converter (DAC) configured to convert the upconverted digital transmission signal into an analog RF transmission signal. For example, the electronic device may include DACs for each RF path. The electronic device may include DACs 230-1, 230-2, ..., and 230-N.

Since a transmission signal of a base station or a terminal in a wireless communication system is transmitted through a wireless channel, it experiences severe attenuation. To this end, the electronic device may be configured to include an amplifier for amplifying a transmission signal. To amplify a signal transmitted to air, a power amplifier may be disposed in the RF path. According to embodiments of the present disclosure, the electronic device may include a Doherty power amplifier. For example, the Doherty power amplifier may be disposed in each RF path. The electronic device may include a plurality of Doherty power amplifiers 240-1, 240-2, ..., and 240-N. An analog RF signal outputted through a DAC 230-i may be amplified through a Doherty power amplifier 240-i. The Doherty power amplifier 240-i may amplify an applied signal and deliver the amplified signal to an antenna 250-i.

As one of techniques for mitigating radio path loss and increasing a propagation distance of radio waves, beamforming technology has been used. Beamforming generally concentrates a coverage area of radio waves or increases directivity of reception sensitivity in a specific direction by using a plurality of antennas. Accordingly, to form beamforming coverage instead of forming a signal with an isotropic pattern using a single antenna, the electronic device may include a plurality of antennas. According to an embodiment, the electronic device may include a Massive MIMO Unit (MMU). A form in which a plurality of antennas are aggregated may be referred to as an antenna array, and each antenna included in the array may be referred to as an array element or an antenna element. The antenna array may be configured in various forms such as a linear array or a planar array. The antenna array may be referred to as a massive antenna array.

For higher data capacity, the number of RF paths should be increased or power per RF path should be increased. As increasing the RF path causes a size of the product to be larger, there are spatial limitations in installing actual base station equipment. In order to increase an antenna gain through higher output without increasing the number of RF paths, a plurality of antenna elements may be connected to one RF path by using a divider (or a splitter) in the RF path. As a signal is radiated through the plurality of antenna elements, the antenna gain may increase. The antenna elements corresponding to an RF path may be referred to as a sub-array.

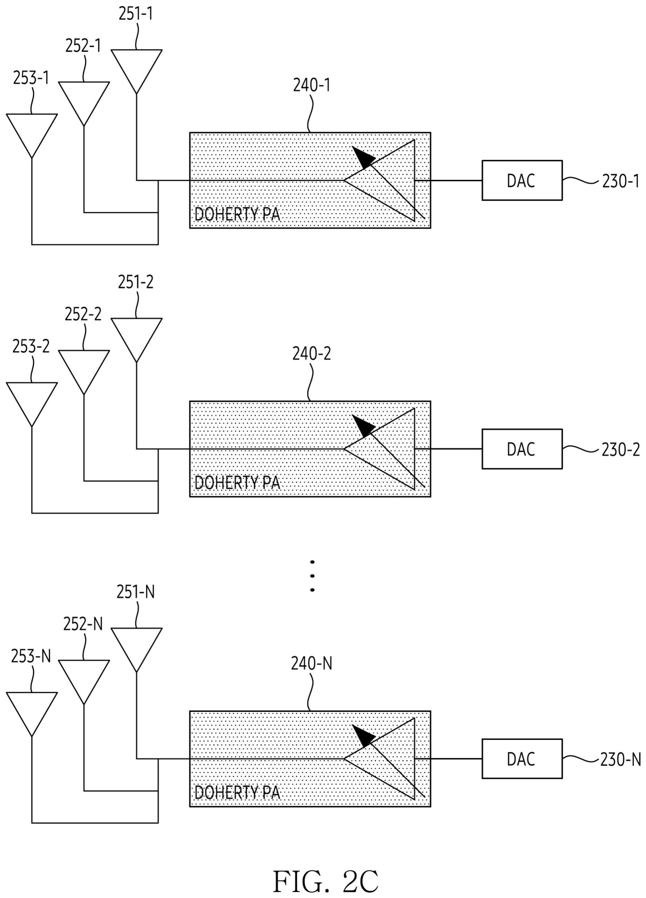

FIG. 2C illustrates another example of an electronic device including a Doherty power amplifier. For example, the electronic device may be a base station 110. For example, the device may be an RU 220. The electronic device may transmit and/or receive a signal by using the above-described sub-array. Hereinafter, in FIG. 2C, a 3x1 sub-array is described as an example.

Referring to FIG. 2C, the electronic device may include a plurality of antennas. The plurality of antennas may be distributed in sub-array units. The sub-array may include a plurality of antenna elements. For example, a first sub-array of the electronic device may include antenna elements 251-1, 251-2, and 251-3. A second sub-array of the electronic device may include antenna elements 252-1, 252-2, and 252-3. In this manner, an Nth sub-array of the electronic device may include antenna elements 251-N, 251-N, and 251-N. The electronic device may include RF processing circuitry to transmit a wireless signal. To radiate signals through the plurality of antennas, the RF processing circuitry may include a plurality of RF paths. For example, the electronic device may include DACs for each RF path. The electronic device may include DACs 230-1, 230-2, ..., and 230-N.

Each RF path may be connected to a sub-array. A sub-array technology refers to a technique for increasing a gain of a corresponding signal by dividing a fed signal into a plurality of antenna elements and feeding the divided signals thereto. The electronic device may include a Doherty power amplifier. For example, a Doherty power amplifier may be disposed in each RF path. The electronic device may include a plurality of Doherty power amplifiers 240-1, 240-2, ..., and 240-N. An analog RF signal outputted through the DAC 230-i may be amplified through the Doherty power amplifier 240-i. The Doherty power amplifier 240-i may amplify the applied signal and transmit the amplified signal to antenna elements 251-1, 252-i, and 253-i of a sub-array of a corresponding RF path.

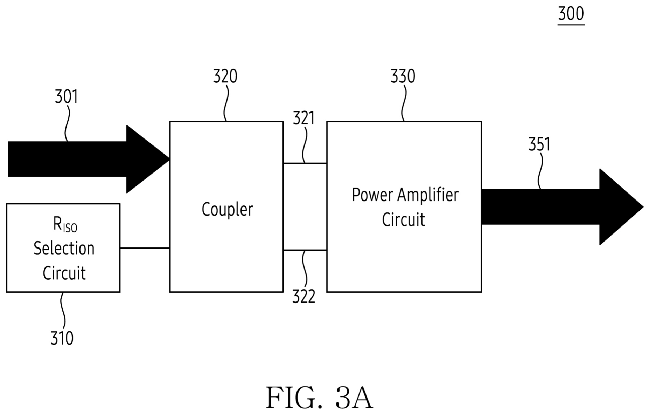

In FIGS. 2B and 2C, RF paths in which the Doherty power amplifier to be proposed through the embodiments of the present disclosure is disposed are described. Meanwhile, the RF path illustrated in FIGS. 2B and 2C is merely an embodiment for explaining a process of delivering an RF signal to a power amplifier and an antenna. For example, components other than those illustrated may be disposed in the RF paths. In addition, FIGS. 2B and 2C should not be construed as excluding RF processing circuitry having a structure different from the illustrated structures and including the Doherty power amplifier described below. Hereinafter, exemplary circuits of the Doherty power amplifier according to the embodiments are described with reference to FIGS. 3A to 8B.

Hereinafter, the present disclosure provides a scheme for improving performance by using a control device of a power divider of the Doherty power amplifier used in a base station or relay system in a wireless communication system. The present disclosure proposes a technique for increasing the efficiency of the power amplifier by allowing an isolation resistor connected to an isolation port in a coupler of the Doherty power amplifier to have an impedance lower than a reference impedance (e.g., about 50 ohms) used for impedance matching. As the efficiency of the power amplifier is improved, power consumption may be reduced.

FIG. 3A illustrates components of a Doherty power amplifier.

Referring to FIG. 3A, a Doherty power amplifier 300 may include a resistor selection circuit 310, a coupler 320, and power amplifier circuitry 330. The resistor selection circuit 310 may provide an isolation resistor. The isolation resistor may indicate a resistive component applied to an isolation port, which is not an input port or an output port, among ports of the coupler 320 described below. The resistor selection circuit 310 may provide a required impedance among a plurality of impedances. The isolation resistor may be represented as an equivalent element having the provided impedance. The provided impedance may be referred to as an isolation impedance. The plurality of impedances may include a reference impedance (e.g., about 50 ohms) used for impedance matching of the coupler 320. The plurality of impedances may include an impedance lower than the reference impedance. Optionally, the plurality of impedances may include an impedance higher than the reference impedance.

According to an embodiment, the resistor selection circuit 310 may include individual resistors having different impedances. The resistor selection circuit 310 may include a switching circuit. The resistor selection circuit 310 may control the switching circuit to electrically connect one of a plurality of resistors to the coupler 320. According to an embodiment, the arrangement of the plurality of resistors may provide a composite resistance value in addition to the unique resistance value according to whether the plurality of resistors are arranged in series or in parallel. For example, a parallel connection of two 50-ohm resistors may indicate an impedance of 25 ohms. In addition, for example, a series connection of two 25-ohm resistors may indicate an impedance of 50 ohms. The resistor selection circuit 310 may control the switching circuit to obtain a desired impedance. The resistor selection circuit 310 may control the switching circuit to electrically connect the coupler 320 with at least two of the plurality of resistors. The impedance of the isolation resistor may be determined according to an arrangement of at least two of the plurality of resistors.

The coupler 320 may operate as a power divider. The coupler 320 may obtain an RF input signal 301. The coupler 320 may distribute the RF input signal 301 to a first RF signal 321 and a second RF signal 322. For example, the coupler 320 may include four ports. The coupler 320 may include a first port for receiving the RF input signal 301. The first port may be referred to as an input port. The coupler 320 may include a second port for an isolation resistor. The second port may be referred to as an isolation port. The coupler 320 may include a third port for providing the first RF signal 321. The third port may be referred to as a first output port. The coupler 320 may include a fourth port for providing the second RF signal 322. The fourth port may be referred to as a second output port. The coupler 320 may be a hybrid coupler. For example, the hybrid coupler may provide output signals having a phase difference of 90 degrees. The hybrid coupler may be referred to as a branch-line coupler. The coupler 320 may distribute the RF input signal 301 applied to the first port to two output signals (e.g., the first RF signal 321 and the second RF signal 322) having equal power and a 90-degree phase difference. The first RF signal 321 may be provided from the third port to the power amplifier circuitry 330. The second RF signal 322 may be provided from the fourth port to the power amplifier circuitry 330.

The power amplifier circuitry 330 may amplify the RF input signal 301 based on the first RF signal 321 and the second RF signal 322. The power amplifier circuitry 330 may provide the amplified signal as an output signal 351 to an antenna end. The power amplifier circuitry 330 may include a carrier amplifier for the first RF signal 321 and a peaking amplifier for the second RF signal 322. The carrier amplifier may be alternatively referred to as a main amplifier, and the peaking amplifier may be alternatively referred to as an auxiliary amplifier. Generally, in a low output state, the carrier amplifier operates to maintain high efficiency, and in a high output state, both amplifiers, that is, the carrier amplifier and the peaking amplifier, may operate in parallel. The carrier amplifier may generally be a class-AB amplifier (whose operating point moves to a class-A bias) or a class-B amplifier (whose operating point is at the cutoff point of a transistor). The peaking amplifier may generally be a class-C amplifier (whose operating point is below the cutoff point of a transistor) that may produce a large amount of distortion. The generated distortion may be offset with the distortion of the carrier amplifier by adjusting the bias, thereby maintaining linearity. The Doherty power amplifier 300 may include a structure for connecting the carrier amplifier and the peaking amplifier. A basic operating principle of the Doherty power amplifier 300 may be explained as load modulation (or active load pull) due to a output current of the peaking amplifier.

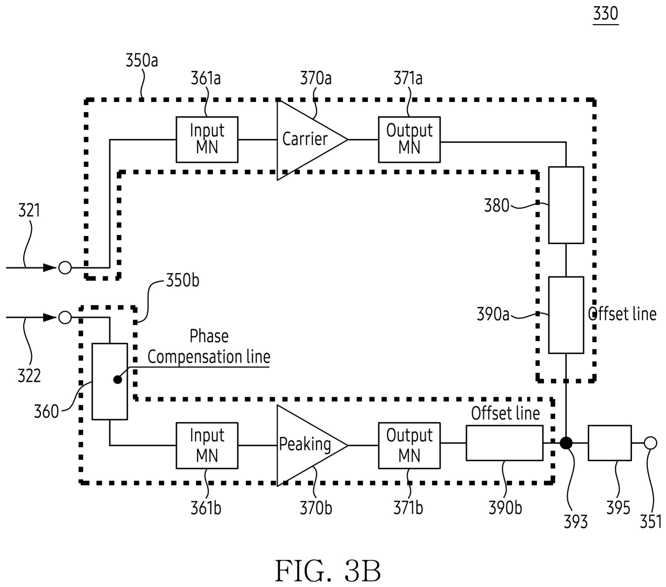

An operating range of the Doherty power amplifier 300 may be classified into three regions, which are a lowest first power level region (e.g., a region backed off by 6 dB or less), a second power level region in which load modulation occurs, and a highest third power level region. In the first power level region, the peaking amplifier does not operate. The peaking amplifier may appear as an open circuit. The carrier amplifier may generate an amplified signal, that is, an output signal 351, based on the first RF signal 321. The efficiency of the carrier amplifier simultaneously increases as the output power increases and may be saturated at a point backed off by 6 dB from the maximum output level. In the second power level region, the carrier amplifier is saturated and may operate at maximum efficiency. If the input power (e.g., power of the RF input signal 301) increases and reaches an intermediate power level backed off by 6 dB, the peaking amplifier may operate. The peaking amplifier may provide an amplified signal based on the second RF signal 322. The carrier amplifier may provide an amplified signal based on the first RF signal 321. The power amplifier circuitry 330 including the carrier amplifier and the peaking amplifier may generate the output signal 351 based on the first RF signal 321 and the second RF signal 322. In the third power level region, both the carrier amplifier and the peaking amplifier are matched, and the power may be distributed at a fixed ratio. The power amplifier circuitry 330 including the carrier amplifier and the peaking amplifier may generate the output signal 351 based on the first RF signal 321 and the second RF signal 322. Components of the power amplifier circuitry 330 are described in detail with reference to FIG. 3B.

FIG. 3B illustrates an example of power amplifier circuitry (e.g., the power amplifier circuitry 330) of a Doherty power amplifier (e.g., the Doherty power amplifier 300).

Referring to FIG. 3B, the power amplifier circuitry 330 may include a carrier amplifier path 350a and a peaking amplifier path 350b. The first RF signal 321 may be amplified through the carrier amplifier path 350a. The carrier amplifier path 350a may include a first input matching network (MN) circuit 361a, a carrier amplifier 370a, a first output matching network circuit 371a, a transmission line 380, and a first offset line 390a. The second RF signal 322 may be amplified through the peaking amplifier path 350b. The peaking amplifier path 350b may include a phase compensation line 360, a second input matching network circuit 361b, a peaking amplifier 370b, a second output matching network circuit 371b, and a second offset line 390b.

The carrier amplifier 370a may be connected to a matching network circuit for impedance matching at both its input and output. The first input matching network circuit 361a may be connected to an input terminal of the carrier amplifier 370a. The first output matching network circuit 371a may be connected to an output terminal of the carrier amplifier 370a. The carrier amplifier path 350a may include an impedance transformer for load modulation after the first output matching network circuit 371a. For example, the impedance converter may include the transmission line 380. The transmission line 380 may have a length of $\lambda/4$ ohms. $\lambda$ may indicate a wavelength of a frequency of a signal. The carrier amplifier path 350a may include the first offset line 390a for compensating and optimizing a parasitic component inside the transistor after the impedance converter.

The peaking amplifier 370b may be connected to a matching network circuit for impedance matching at both its input and output. The second input matching network circuit 361b may be connected to an input terminal of the peaking amplifier 370b. The second output matching network circuit 371b may be connected to an output terminal of the peaking amplifier 370b. The carrier amplifier path 350a and the peaking amplifier path 350b may be disposed in parallel. To compensate for a phase difference caused by the parallel arrangement, a phase compensation line 360 may be disposed. The peaking amplifier path 350b may include the phase compensation line 360 for compensating for a phase difference between the first RF signal 321 and the second RF signal 322. The peaking amplifier path 350b may include the second offset line 390b to compensate for a parasitic component inside a transistor after an impedance transformer to enable load modulation.

At a combining end 393, the amplified first RF signal and the amplified second RF signal may be combined. The power amplifier circuitry 330 may include an impedance transformer for impedance matching of the combined signal. The combining node 393 may be connected to an impedance transformer for matching with an external reference impedance (e.g., about 50 ohms). For example, the impedance transformer may include a transmission line having a $\lambda/4$ length of about $\frac{50}{\sqrt{2}}$ (about 35.35) ohms.

FIG. 4 is a diagram for explaining a principle of a coupler (e.g., the coupler 320) for a Doherty power amplifier. The coupler 320 may include a hybrid coupler. For example, the coupler 320 may include a hybrid coupler having a 90-degree phase difference. The coupler 320 may be referred to as a branch-line coupler. Alternatively, the coupler 320 may be referred to as a 3- decibel (dB) hybrid coupler.

Referring to FIG. 4, the coupler 320 may include four ports. The coupler 320 may include a first port 401, a second port 402, a third port 403, and a fourth port 404. The first port 401 of the coupler 320 may be an input port for obtaining an RF input signal 301. The second port 402 of the coupler 320 may be an isolation port connected to an isolation resistor Riso. According to embodiments, the second port 402 of the coupler 320 may be electrically connected to a resistor selection circuit 310 for providing the isolation resistor Riso. For example, according to an embodiment, the resistor selection circuit 310 may provide an impedance lower than a reference impedance used for impedance matching of the coupler 320 and the power amplifier circuitry 330. A resistive component for the impedance may be referred to as the isolation resistor Riso. An impedance of the isolation resistor Riso may be referred to as an isolation impedance. Since the impedance of the isolation resistor is fixed during signal distribution, an isolation characteristic may be ensured, and the RF input signal 301 may be distributed such that power of the first RF signal 321 and power of the second RF signal 322 are identical. The third port 403 of the coupler 320 may be a first output port for outputting the first RF signal 321. The fourth port 404 of the coupler 320 may be a second output port for outputting the second RF signal 322.

The coupler 320 may operate as a power distributor. The coupler 320 may distribute the RF input signal 301 with the same power. The coupler 320 may distribute the RF input signal 301 into the first RF signal 321 and the second RF signal 322 having the same power. The coupler 320 may include a plurality of transmission lines for power distribution. The coupler 320 may include a first transmission line 411, a second transmission line 412, a third transmission line 413, and a fourth transmission line 414. The first transmission line 411 may have a phase difference (e.g., $\lambda/4$ ) of 90 degrees and an impedance of $\frac{Z_0}{\sqrt{2}}$ ohms. $Z_0$ indicates a reference impedance for impedance matching. For example, $Z_0$ may be 50 ohms. The second transmission line 412 may have a phase difference (e.g., $\lambda/4$ ) of 90 degrees, and may have an impedance of $Z_0$ ohm. The third transmission line 413 may have a phase difference (e.g., $\lambda/4$ ) of 90 degrees, and may have an impedance of $\frac{Z_0}{\sqrt{2}}$ ohm. The fourth transmission line 414 may have a phase difference (e.g., $\lambda/4$ ) of 90 degrees, and may have an impedance of $Z_0$ ohm.

Each port of the coupler 320 may be matched to a reference impedance (e.g., impedance matching). For example, each of the first port 401, the second port 402, the third port 403, and the fourth port 404 of the coupler 320 may be matched to 50 ohms. A first input impedance $Z_{in,C}$ of the carrier amplifier path 350a connected to the third port 403 may be matched to the reference impedance. For example, the first input impedance $Z_{in,C}$ may be matched to 50 ohms. A second input impedance $Z_{in,P}$ of the peaking amplifier path 350b connected to the fourth port 404 may be matched to the reference impedance. For example, the second input impedance $Z_{in,P}$ may be matched to 50 ohms.

An element in which the carrier amplifier 370a and the peaking amplifier 370b vary according to input power (e.g., power of the RF input signal 301) is an input capacitance. The input capacitance may vary according to a bias condition of an amplifier. Since the carrier amplifier 370a operates as a class-AB amplifier, an input capacitance $C_{inp,c}$ of the carrier amplifier 370a may have a constant magnitude according to input power. The peaking amplifier 370b may operate as a class-C amplifier. For example, the peaking amplifier 370b may include a metal oxide semiconductor field effect transistor (MOSFET) amplifier. It may be understood that an input capacitance 450 $C_{inp,p}$ is disposed between a gate terminal and a source terminal of the peaking amplifier 370b. Due to a characteristic (e.g., a DC operating point below a cutoff point) of a class-C amplifier, the input capacitance 450 $C_{inp,p}$ of the peaking amplifier 370b may have a characteristic of increasing nonlinearly according to input power (e.g., power applied to the peaking amplifier path 350a). The above-described input capacitance 450 $C_{inp,p}$ may be represented as being disposed between the fourth port 404 of the coupler 320 and the peaking amplifier path 350b. For example, the input capacitance 450 $C_{inp,p}$ of the peaking amplifier path 350b may have a negative capacitance within a range where input power is below a reference value. As the input power increases, the input capacitance 450 $C_{inp,p}$ may increase. If the input power reaches a maximum, the input capacitance 450 $C_{inp,p}$ may have zero capacitance.

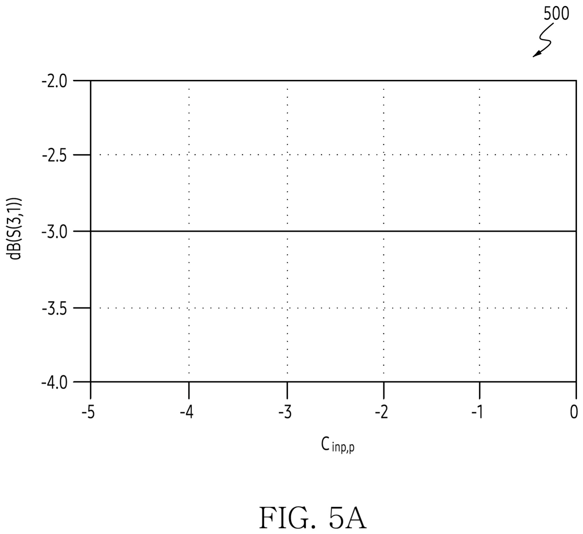

FIG. 5A illustrates power to a carrier amplifier according to an input capacitance (e.g., the input capacitance 450) of a peaking amplifier. The input capacitance means the input capacitance 450 $C_{inp, p}$ of the peaking amplifier.

Referring to FIG. 5A, a graph 500 illustrates a first power ratio to a carrier amplifier according to the input capacitance 450. A horizontal axis of the graph 500 indicates the input capacitance 450, and a vertical axis of the graph 500 indicates the first power ratio. The first power ratio may indicate a transmission coefficient (e.g., S-parameter, S(3,1) based on the coupler 320 of FIG. 4) of a first output port with respect to an input port based on the coupler 320. Since the carrier amplifier 370a operates as a class-AB amplifier, there is substantially no change in input capacitance at a side of the third port 403. For example, the third port 403 may always be matched with the carrier amplifier path 350a. Regardless of a change in the input capacitance 450, the first power ratio may be fixedly maintained. For example, even if the input capacitance 450 changes when input power increases, a ratio of power of the first RF signal 321 with respect to power of the RF input signal 301 may be substantially maintained. For example, the first power ratio may be about 1/2 (about -3 dB) regardless of the input capacitance 450.

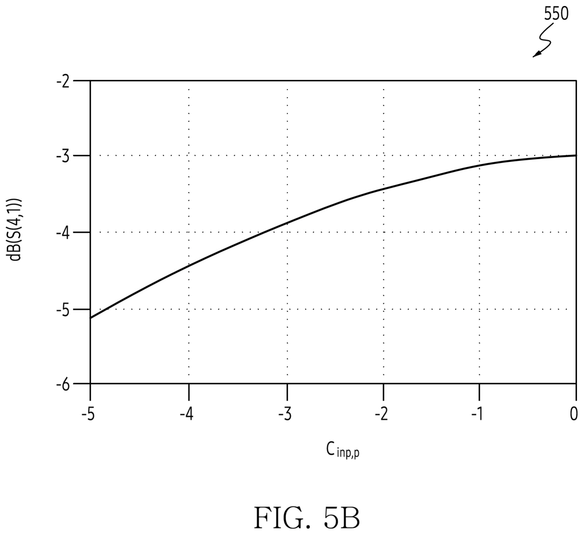

FIG. 5B illustrates power to a peaking amplifier according to an input capacitance of the peaking amplifier. The input capacitance means the input capacitance 450 $C_{inp, p}$ of the peaking amplifier.

Referring to FIG. 5B, a graph 550 illustrates a second power ratio to a peaking amplifier according to the input capacitance 450. A horizontal axis of the graph 500 indicates the input capacitance 450, and a vertical axis of the graph 500 indicates the second power ratio. The second power ratio may indicate a transmission coefficient (e.g., S-parameter, S(4,1) based on the coupler 320 of FIG. 4) of a second output port with respect to an input port based on the coupler 320. Based on a change in the input capacitance 450, the second power ratio may increase. For example, when input power increases, the input capacitance 450 may increase. As the input capacitance 450 increases, the second power ratio of the second RF signal 322 with respect to power of the RF input signal 301 may also increase. As the input capacitance 450 increases, S(4,1) may increase from about (-)5 dB to about (-)3 dB. When the input capacitance 450 becomes maximum (e.g., zero), the second power ratio of the second RF signal 322 may be 1/2 (about -3 dB). When the input capacitance 450 becomes maximum, the coupler 320 may be matched. Power of the RF input signal 301 may be equally distributed into power of the first RF signal 321 applied to the carrier amplifier 370a and power of the second RF signal 322 applied to the peaking amplifier 370b.

Efficiency of a power amplifier, which consumes the largest power in a transmitter, is highly important. A wireless communication system may use a modulation scheme such as Orthogonal Frequency Division Multiplexing (OFDM). Due to a modulation signal having a high peak-to-average power ratio (PAPR), in order to transmit an information signal without distortion, the power amplifier needs to operate in a back-off region. The back-off region indicates an operation range having reduced output power from a maximum power point for linearity of the power amplifier. However, since the power amplifier in the back-off region cannot be saturated, it has relatively low power efficiency. A Doherty power amplifier (e.g., the Doherty power amplifier 300) may improve efficiency in the back-off region by using a load modulation scheme. The Doherty power amplifier may include a carrier amplifier 370a and a peaking amplifier 370b. In a high output power region (e.g., third power level region), two amplifiers (e.g., the carrier amplifier 370a and the peaking amplifier 370b) deliver maximum output to a load, while in a low output power region (e.g., first power level region), the peaking amplifier 370b may be turned off. When exceeding the first power level region, the peaking amplifier 370b may operate together with the carrier amplifier 370a. As load impedances of the carrier amplifier 370a and the peaking amplifier 370b are modulated according to magnitudes of output power, efficiency in the back-off region may be improved. If a resistor connected to an isolation port (e.g., the second port 402) of the coupler 320 is fixed to a reference impedance, a fixed power distribution may be performed regardless of a magnitude of the RF input signal 301. That is, power of the RF input signal 301 may always be distributed into power of the first RF signal 321 and power of the second RF signal 322 in a fixed ratio (e.g., 1:1).

Since the peaking amplifier 370b is turned off in a first power level region, a power loss of about 3 dB may occur. In addition, at a maximum output power, since the peaking amplifier 370b operates as a class-C amplifier, the peaking amplifier 370b has a lower power gain than the carrier amplifier 370a. Accordingly, if the same input power as that of the carrier amplifier 370a is applied to the peaking amplifier 370b, the Doherty power amplifier 300 may have difficulty reaching a maximum output power. Low output power of the peaking amplifier 370b may cause a decrease in overall output of the Doherty power amplifier 300 and may cause incomplete load modulation. The above-described problems may reduce efficiency of the Doherty power amplifier 300. The reduced efficiency may increase current consumption of the Doherty power amplifier 300.

Embodiments of the present disclosure propose a method for improving a characteristic (e.g., efficiency) across an overall output power range of the Doherty power amplifier 300 by controlling an input power distribution ratio of the coupler 320 of the Doherty power amplifier 300. In order to overcome a power loss (e.g., 3 dB) occurring as the peaking amplifier 370b is turned off in the first power level region, the Doherty power amplifier 300 according to embodiments of the present disclosure may control power to be input more into the carrier amplifier 370a than a fixed ratio (e.g., 1/2) in the first power level region. In the first power level region, efficiency may be improved due to higher power gain and saturated operation of the carrier amplifier 370a. In addition, in the third power level region, the same input power as that of the carrier amplifier 370a may be applied to the peaking amplifier 370b, thereby addressing a problem of not reaching a maximum output power. The present disclosure proposes a method for improving a characteristic of the Doherty power amplifier 300 by changing an operation manner according to output power, while scarcely increasing circuit complexity compared to a general Doherty power amplifier 300. Furthermore, since it may operate variably over a wide output power range, an electronic device (e.g., the base station 110, the radio unit 220) may provide an improved characteristic for various use cases.

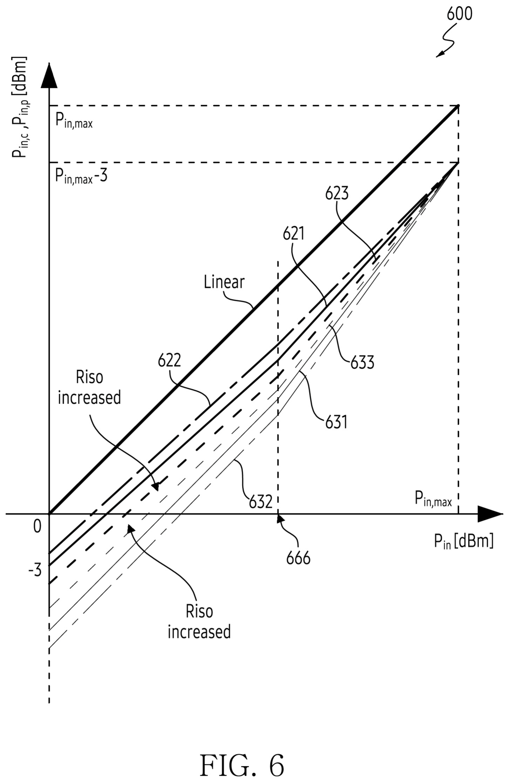

FIG. 6 illustrates an example of power distribution for each isolation resistor. The isolation resistor indicates a resistor connected to an isolation port of a coupler (e.g., the coupler 320) provided through the resistor selection circuit 310.

Referring to FIG. 6, a graph 600 indicates a magnitude of distributed power with respect to input power $P_{in}$. A horizontal axis of the graph 600 indicates the input power $P_{in}$ (unit: decibel milliwatt (dBm)), and a vertical axis of the graph 600 indicates distributed power (unit: dBm). The distributed power may be first power $P_{in,c}$ distributed from the input power $P_{in}$ to the carrier amplifier path 350a or second power $P_{in,p}$ distributed to the peaking amplifier path 350b. The isolation resistor may be a reference impedance, a first impedance smaller than the reference impedance, or a second impedance greater than the reference impedance. The reference impedance may be an impedance used for impedance matching of each port of the coupler 320. For example, the reference impedance may be 50 ohms. For example, the first impedance may be 25 ohms. For example, the second impedance may be about 70.7 ohms.

The first power $P_{in,c}$ with respect to the input power $P_{in}$ may be identified through a first main line 621, a second main line 622, and a third main line 623. The first main line 621, the second main line 622, and the third main line 623 may be distinguished by magnitudes of isolation resistors. The first main line 621 indicates a magnitude of the first power $P_{in,c}$ distributed according to the reference impedance. The second main line 622 indicates a magnitude of the first power $P_{in,c}$ distributed according to the first impedance. The third main line 623 indicates a magnitude of the first power $P_{in,c}$ distributed according to the second impedance. The second power $P_{in,p}$ with respect to the input power $P_{in}$ may be identified through a first auxiliary line 631, a second auxiliary line 632, and a third auxiliary line 633. The first auxiliary line 631, the second auxiliary line 632, and the third auxiliary line 633 may be distinguished by magnitudes of isolation resistors. The first auxiliary line 631 indicates a magnitude of the second power $P_{in,p}$ distributed according to the reference impedance. The second auxiliary line 632 indicates a magnitude of the second power $P_{in,p}$ distributed according to the first impedance. The third auxiliary line 633 indicates a magnitude of the second power $P_{in,p}$ distributed according to the second impedance.

It is assumed that the isolation resistor is the reference impedance. By referring to the first main line 621 and the first auxiliary line 631, it may be confirmed that in an input power $P_{in}$ range below a reference point 666, the input power $P_{in}$ is distributed into first power $P_{in,c}$ and second power $P_{in,p}$, according to a specified ratio. As an example, a slope of the first main line 621 in the input power $P_{in}$ range below the reference point 666 may be substantially identical to a slope of the first auxiliary line 631. A distribution ratio according to the first impedance may differ from a distribution ratio at the reference impedance. The distribution ratio according to the first impedance may indicate that more power is allocated to the carrier amplifier 370a than a distribution ratio at the reference impedance. Since the impedance of the isolation resistor is lower than the reference impedance, first power $P_{in,c}$ distributed to the carrier amplifier 370a when the isolation resistor is the first impedance may be greater than the first power distributed when the isolation resistor is the reference impedance. In contrast, second power $P_{in,p}$ distributed to the peaking amplifier 370b when the isolation resistor is the first impedance may be less than the second power distributed when the isolation resistor is the reference impedance. In other words, input power applied to the peaking amplifier 370b may decrease. For another example, it is assumed that the isolation resistor is changed to the second impedance. By referring to the third main line 623 and the third auxiliary line 633, it may be confirmed that in an input power $P_{in}$ range below the reference point 666, the input power $P_{in}$ is distributed into first power $P_{in,c}$ and second power $P_{in,p}$ according to a specified ratio. For example, a slope of the third main line 623 in the input power $P_{in}$ range below the reference point 666 may be substantially identical to a slope of the third auxiliary line 633. A distribution ratio according to the second impedance may differ from a distribution ratio at the reference impedance. The distribution ratio according to the second impedance may indicate that more power is allocated to the peaking amplifier 370b than the distribution ratio at the reference impedance. Since the impedance of the isolation resistor is higher than the reference impedance, first power $P_{in,c}$ distributed to the carrier amplifier 370a when the isolation resistor is the second impedance may be less than the first power distributed when the isolation resistor is the reference impedance. In contrast, second power $P_{in,p}$ distributed to the peaking amplifier 370b when the isolation resistor is the second impedance may be greater than the second power distributed when the isolation resistor is the reference impedance.

If input power $P_{in}$ exceeding the reference point 666 is applied, the peaking amplifier 370b may operate. For example, output power at the reference point 666 may have a magnitude backed off by about 6 dB from the maximum output power. If the peaking amplifier 370b operates, a second power ratio of the peaking amplifier 370b may increase nonlinearly. By referring to the first auxiliary line 631, the second auxiliary line 632, and the third auxiliary line 633, it may be identified that slopes sharply increase around the reference point 666. When a magnitude of total input power $P_{in}$ becomes maximum, since the carrier amplifier 370a and the peaking amplifier 370b are both in a completely matched state, input power of each of the carrier amplifier 370a and the peaking amplifier 370b becomes equal. In the state that they are all matched, regardless of a magnitude of an impedance of the isolation resistor, a ratio between the first power $P_{in,c}$ and the second power $P_{in,p}$ becomes fixed (e.g., substantially identical ratio of 1:1).

The second power $P_{in,p}$ distributed to the peaking amplifier 370b before the reference point 666 may be distributed, but may not be used for signal amplification. This is because the peaking amplifier 370b is not activated. Since only the carrier amplifier 370a operates in an operation range below the reference point 666 (e.g., the first power level region), efficiency decreases due to the second power $P_{in,p}$. To improve efficiency, a characteristic in which more power is distributed to the carrier amplifier 370a as an impedance of an isolation resistor becomes lower may be utilized. The Doherty power amplifier 300 according to embodiments of the present disclosure may provide efficiency improvement of the Doherty power amplifier 300 in the first power level region by connecting an isolation resistor having an impedance lower than the reference impedance with the coupler 320. In addition, as the same input power are respectively applied to a carrier amplifier and a peaking amplifier in a maximum output power range (e.g., the third power level region), efficiency of the Doherty power amplifier may be improved. As an isolation resistor having a first impedance lower than the reference impedance is provided to the coupler 320, the carrier amplifier 370a becomes more saturated in a back-off region, thereby increasing efficiency. The maximum output power may be maintained at a level equivalent to output power when the reference impedance is applied.

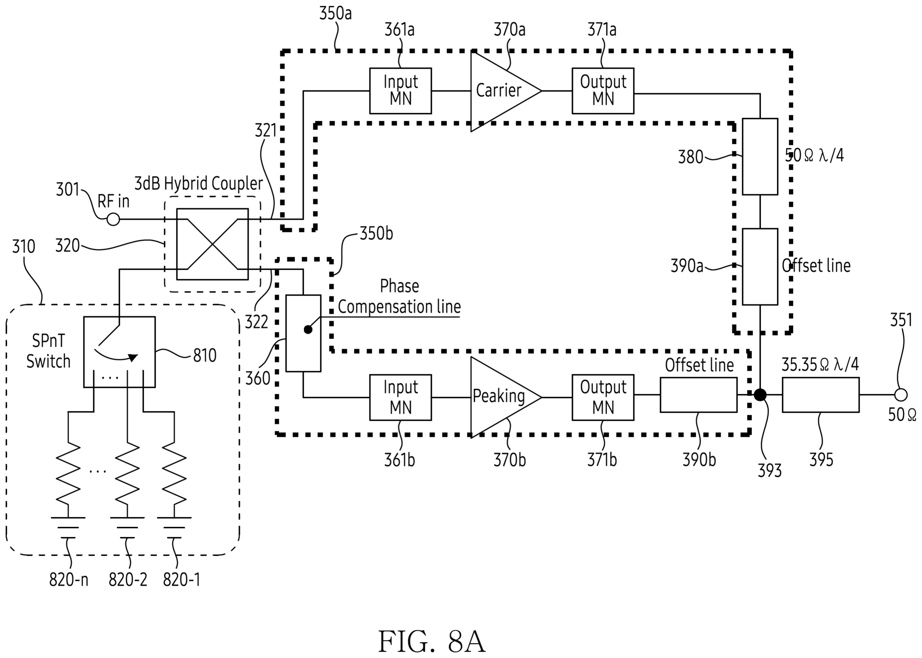

Efficiency of a power amplifier has a trade-off relationship with gain. According to an embodiment, power gain (e.g., amplitude modulation to amplitude modulation (AM-AM)) may be adjusted through selection of an isolation resistor. Control of the power gain may be associated with linearity of a Doherty power amplifier. As power consumption increases to satisfy linearity, efficiency may decrease. According to an embodiment, a control circuit of an electronic device may be configured to identify an isolation resistor in the resistor selection circuit 310 to control power gain. Selection of the isolation resistor is described in detail with reference to FIGS. 8A to 8B.

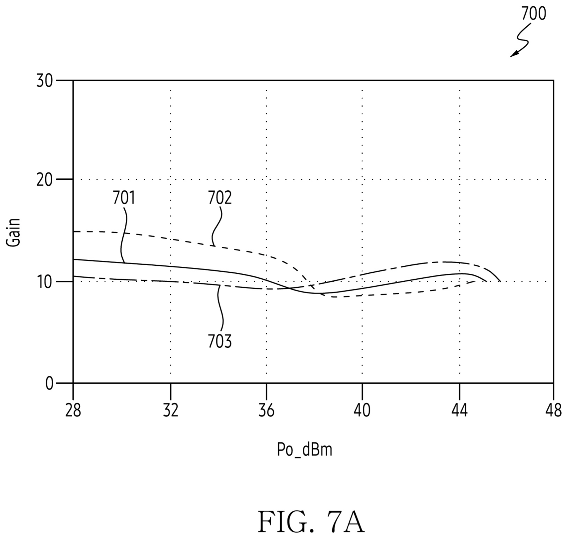

FIG. 7A illustrates an example of gains for each isolation resistor.

Referring to FIG. 7A, a graph 700 indicates gain of the Doherty power amplifier 300 with respect to output power. A horizontal axis of the graph 700 indicates output power (unit: dBm), and a vertical axis of the graph 700 indicates gain (unit: dBm). A first line 701 indicates gain of the Doherty power amplifier 300 when the isolation resistor provides a reference impedance. A second line 702 indicates gain of the Doherty power amplifier 300 when the isolation resistor provides a first impedance (e.g., 25 ohms) lower than the reference impedance. A third line 703 indicates gain of the Doherty power amplifier 300 when the isolation resistor provides a second impedance (e.g., 70.7 ohms) higher than the reference impedance. It may be identified that gain is improved based on an isolation resistor having an impedance (e.g., the first impedance) lower than the reference impedance in a low output power range (e.g., equal to or lower than about 38 dBm), but gain is decreased in a high output power range (e.g., equal to or higher than about 38 dBm). On the other hand, it may be identified that an isolation resistor having an impedance (e.g., the second impedance) higher than the reference impedance provides low gain in the low output power range (e.g., equal to or lower than about 37 dBm) but gain is increased in the high output power range (e.g., equal to or higher than about 38 dBm).

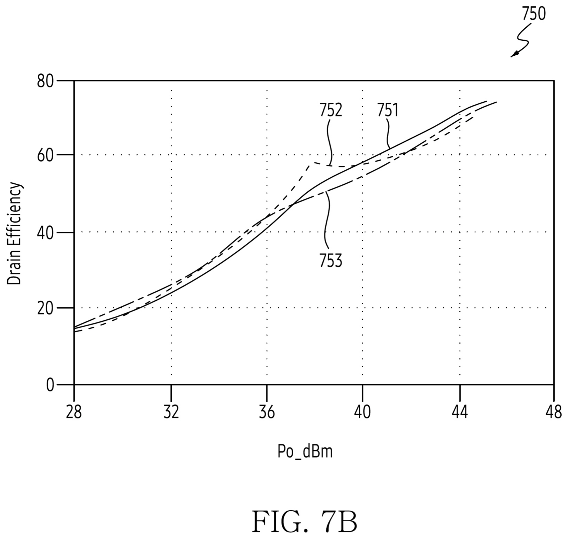

FIG. 7B illustrates an example of drain efficiency (DE) for each isolation resistor.

Referring to FIG. 7B, a graph 750 indicates drain efficiency of the Doherty power amplifier 300 with respect to output power. A horizontal axis of the graph 750 indicates output power (unit: dBm), and a vertical axis of the graph 750 indicates drain efficiency. The drain efficiency, which is an example of amplifier efficiency, may indicate a ratio of RF output power with respect to DC input power, in a transistor of a field effect transistor (FET) series. A first line 751 indicates drain efficiency of the Doherty power amplifier 300 when an isolation resistor provides a reference impedance. A second line 752 indicates drain efficiency of the Doherty power amplifier 300 when the isolation resistor provides a first impedance (e.g., 25 ohms) lower than the reference impedance. A third line 753 indicates drain efficiency of the Doherty power amplifier 300 when the isolation resistor provides a second impedance (e.g., 70.7 ohms) higher than the reference impedance. Referring to the graph 750, it may be identified that drain efficiency of the isolation resistor having the first impedance is the highest at about 35 dBm. On the other hand, it may be identified that drain efficiency of the isolation resistor having the second impedance is decreased at about 35 dBm.

Referring to the graphs 700 and 750, it may be identified that gain change according to output power and efficiency (e.g., AM-AM drain efficiency) of a power amplifier have a trade-off relationship in accordance with a change in an impedance value of an isolation resistor. Hereinafter, examples for controlling gain and efficiency of the Doherty power amplifier 300 by adaptively providing a specific impedance among a plurality of impedances of the resistor selection circuit 310 are described in detail with reference to FIGS. 8A to 8B.

FIG. 8A illustrates an exemplary circuit of a Doherty power amplifier (e.g., the Doherty power amplifier 300) including a resistor selection circuit (e.g., the resistor selection circuit 310). In FIG. 8A, a specific circuit of the Doherty power amplifier 300 including the power amplifier circuitry 330 of FIG. 3B and the coupler 320 of FIG. 4 is described. The same descriptions may be applied through the same reference numerals.

Referring to FIG. 8A, the Doherty power amplifier 300 may include a resistor selection circuit 310. According to an embodiment, the resistor selection circuit 310 may include a switching circuit 810 and a plurality of resistors 820-1, 820-2, ..., and 820-n. For example, the switching circuit 810 may include a single pole n-throw (SPnT) switch. For example, the plurality of resistors 820-1, 820-2, ..., and 820-n may be arranged in an array form. The resistor selection circuit 310 may provide a plurality of impedances. The resistor selection circuit 310 may provide one among the plurality of impedances as an impedance of an isolation resistor. The resistor selection circuit 310 may control the switching circuit 810 to provide an impedance of the isolation resistor. Although n resistors are described in FIG. 8A, an arrangement of one resistor (e.g., a resistor having an impedance lower than the reference impedance) and/or two resistors (a resistor of the reference impedance and a resistor having an impedance lower than the reference impedance) may also be understood as an embodiment of the present disclosure.

The plurality of resistors 820-1, 820-2, ..., and 820-n may have different impedances. According to an embodiment, a plurality of impedances provided through the plurality of resistors 820-1, 820-2, ..., and 820-n may include a reference impedance and a first impedance. The reference impedance, which is a resistance value used for impedance matching of the coupler 320, may be, for example, 50 ohms. The first impedance may be lower than the reference impedance value to increase amplifier efficiency during a certain operation range. Since the power distribution ratio to the carrier amplifier path 350a at the first impedance is greater than the power distribution ratio to the carrier amplifier path 350a at the reference impedance, efficiency of the Doherty power amplifier 300 may be improved in a first power level region (e.g., back-off region of 6 dB or lower). The plurality of resistors 820-1, 820-2, ..., and 820-n may include a resistor having the reference impedance and a resistor having the first impedance. For example, the resistor 820-1 may have an impedance of about 50 ohms. For example, the resistor 820-2 may have an impedance of about 25 ohms. In addition, according to an embodiment, the plurality of impedances provided through the plurality of resistors 820-1, 820-2, ..., and 820-n may include the reference impedance, the first impedance, and a second impedance. The second impedance may be greater than the reference impedance value to increase gain during a certain operation range. Since the power distribution ratio to the peaking amplifier path 350a at the second impedance is greater than the power distribution ratio to the peaking amplifier path 350a at the reference impedance, gain of the Doherty power amplifier 300 may be improved in a first power level region (e.g., a back-off region of 6 dB or lower). The plurality of resistors 820-1, 820-2, ..., and 820-n may include a resistor having the reference impedance, a resistor having the first impedance, and a resistor having the second impedance. For example, the resistor 820-1 may have an impedance of about 50 ohms. For example, the resistor 820-2 may have an impedance of about 25 ohms. For example, the resistor 820-n may have an impedance of about 70.7 ohms.

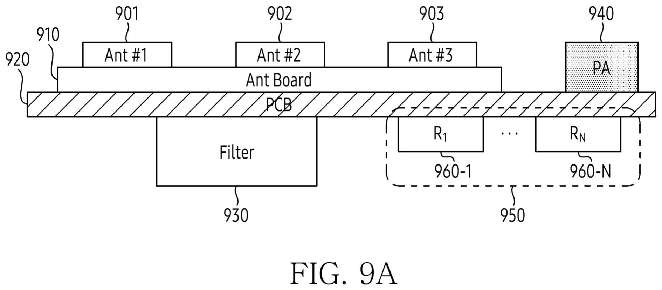

A method in which the switching circuit 810 selects an individual resistor to allow the resistor selection circuit 310 to provide a plurality of impedances has been described. However, embodiments of the present disclosure are not limited thereto. Various methods of providing a variable impedance may be used for the resistor selection circuit 310 of the present disclosure. According to an embodiment, in order to reduce a magnitude of physical resistor, a parallel arrangement of resistors or a series arrangement of resistors may be used. For example, among the plurality of resistors within the resistor selection circuit 310, a first resistor and a second resistor may be arranged in parallel. For example, the first resistor may have an impedance of about 50 ohms, and the second resistor may have an impedance of about 25 ohms. In a case that an impedance higher than the reference impedance of 50 ohms is required, the resistor selection circuit 310 may operate the switch such that the first resistor and the second resistor are connected in series. In another example, the first resistor may have an impedance of about 50 ohms, and the second resistor may have an impedance of about 25 ohms. To further increase a power ratio applied to the carrier amplifier, an impedance lower than about 25 ohms may be required. The resistor selection circuit 310 may operate the switch such that the first resistor and the second resistor are connected in parallel. In yet another example, the first resistor may have an impedance of about 50 ohms, and the second resistor may have an impedance of about 50 ohms. To reduce a magnitude of the impedance connected to the coupler 320, the resistor selection circuit 310 may operate the switch such that the first resistor and the second resistor are connected in parallel. According to an embodiment, the first resistor may be used for an RF path for a first polarization of a sub-array, and the second resistor may be used for an RF path for a second polarization of the sub-array. In another embodiment, the first resistor may be used for an RF path for a first sub-array, and the second resistor may be used for an RF path for a second sub-array. To reduce the impedance magnitude within a limited space, a resistor may be shared between two RF paths. Examples of arrangements of resistors within a physical space are described in detail with reference to FIGS. 9A to 9C.

To provide a plurality of desired impedances, a variable resistor capable of arbitrarily changing a resistance value in an electronic circuit may be considered in the resistor selection circuit 310, but the variable resistor has a characteristic of providing relatively small resistance values. That is, to accommodate a variation range of antennas and power amplifiers required in the base station 110 or the RU 220, the resistor selection circuit 310 may be advantageous instead of the variable resistor. By controlling electrical connections of physically arranged resistors through the switching circuit 810, the resistor selection circuit 310 may provide a sufficient variation range.

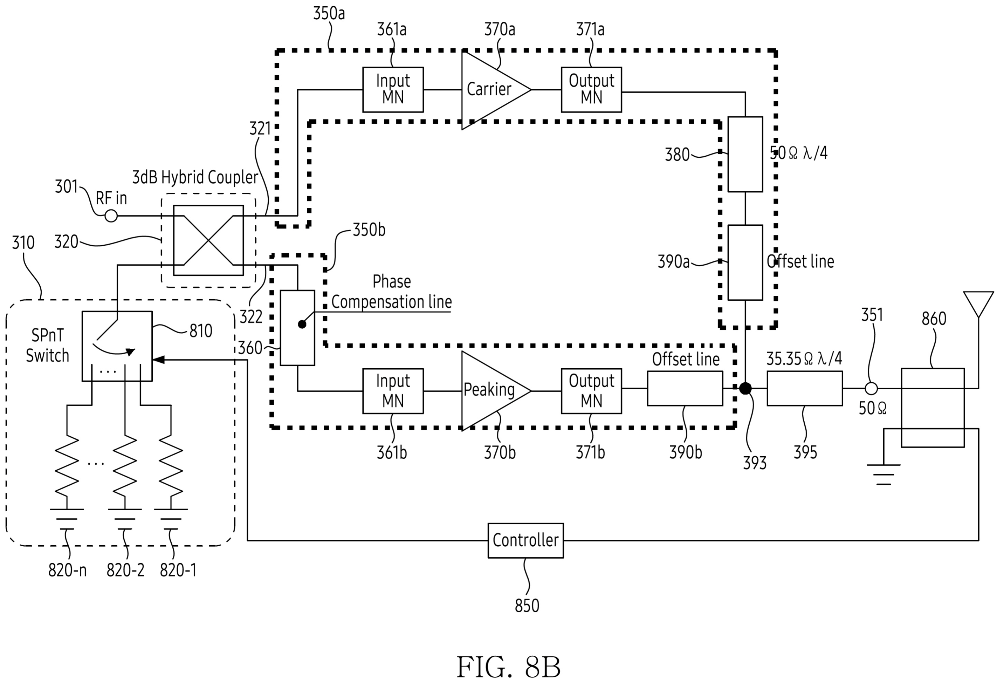

FIG. 8B illustrates an exemplary circuit of a Doherty power amplifier (e.g., the Doherty power amplifier 300) including a feedback circuit. In FIG. 8B, a specific circuit of the Doherty power amplifier 300 including the power amplifier circuitry 330 of FIG. 3B and the coupler 320 of FIG. 4 is described. The same description may be applied through the same reference numerals. The description regarding the resistor selection circuit 310 in FIG. 8A may also be applied in the same manner to FIG. 8B.

Referring to FIG. 8B, the Doherty power amplifier 300 may be connected to a controller 850 and a feedback coupler 860. It may be included. The feedback coupler 860 may obtain a feedback signal coupled from at least a portion of a signal provided to an antenna end (e.g., an antenna or a sub-array). The feedback coupler 860 may obtain a feedback signal provided to the antenna end and provide it to the controller 850. The controller 850 may control the resistor selection circuit 310 based on the feedback signal. The controller 850 may control selection of an isolation resistor of the resistor selection circuit 310 based on the feedback signal.

According to an embodiment, the controller 850 may control the resistor selection circuit 310 based on a magnitude of a feedback signal. In general, the feedback signal may be associated with control of linearity. In the present disclosure, the controller 850 may adjust a relationship between efficiency and gain through the magnitude of the feedback signal. The controller 850 may obtain power efficiency of the Doherty power amplifier 300 from the magnitude of the feedback signal. The controller 850 may determine whether to secure additional efficiency or to increase gain, based on the obtained power efficiency. For example, the controller 850 may control the resistor selection circuit 310 to select an isolation resistor having an impedance (e.g., about 25 ohms, about $50/\sqrt{2}$ ohms) lower than a current impedance (e.g., the reference impedance) to further increase amplifier efficiency. In another example, to increase gain instead of power efficiency, the controller 850 may control the resistor selection circuit 310 to select an isolation resistor having an impedance (e.g., about $50/\sqrt{2}$ ohms, about 100 ohms) higher than the current impedance (e.g., the reference impedance).

According to another embodiment, the controller 850 may control the resistor selection circuit 310 based on a characteristic of a feedback signal. Through the feedback signal, a DC current characteristic supplied to the carrier amplifier 370a and the peaking amplifier 370b may be obtained. For example, the controller 850 may control the resistor selection circuit 310 to select an isolation resistor having an impedance (e.g., about 25 ohms, about ohms) lower than a current impedance (e.g., a reference impedance) to increase a ratio of power supplied to the carrier amplifier 370a relative to power supplied to the peaking amplifier 370b. In another example, to decrease a ratio of power supplied to the carrier amplifier 370a relative to power supplied to the peaking amplifier 370b, the controller 850 may control the resistor selection circuit 310 to select an isolation resistor having an impedance (e.g., about $50/\sqrt{2}$ ohms, about 100 ohms) higher than the current impedance (e.g., the reference impedance).

In FIG. 8B, examples in which the controller 850 controls selection of an isolation resistor of the resistor selection circuit 310 based on a feedback signal are described, but embodiments of the present disclosure are not limited thereto. The controller 850 may control selection of the isolation resistor of the resistor selection circuit 310 based on a metric distinguished from the feedback signal or based on both the feedback signal and the metric.

According to an embodiment, the controller 850 may control the resistor selection circuit 310 based on a traffic load. Based on a control signal of the controller 850, the resistor selection circuit 310 may be configured to select an isolation resistor having one among a plurality of impedances. As described through FIGS. 5A to 7B, if the isolation resistor is set to an impedance lower than a reference impedance (e.g., 50 ohms), efficiency of the Doherty power amplifier 300 may be improved in a specific output range (e.g., the first power level region), while gain may be decreased. Through such a trade-off relationship, the controller 850 may control selection of the isolation resistor based on the traffic load. For example, in a case that traffic is greater than a threshold value, the controller 850 may control the resistor selection circuit 310 to identify an isolation resistor having an impedance (e.g., about 25 ohms, about $50/\sqrt{2}$ ohms) lower than the reference impedance. Due to linearity of the power amplifier, heat generation may increase as the traffic becomes higher. To reduce heat generation, low-output and high-efficiency may be required. If the isolation resistor is decreased to an impedance (e.g., about 25 ohms, about $50/\sqrt{2}$ ohms) lower than the reference impedance (e.g., about 50 ohms), more power is distributed to the carrier amplifier 370a as described through FIG. 6, so efficiency may increase. In another example, in a case that the traffic is less than or equal to the threshold value, the controller 850 may control the resistor selection circuit 310 to identify an isolation resistor having an impedance (e.g., about $50/\sqrt{2}$ ohms, about 100 ohms) higher than the reference impedance.

According to an embodiment, the controller 850 may control the resistor selection circuit 310 based on a symbol. A power amplifier may be required to provide a linear output relative to an input power. Such a characteristic may be referred to as linearity. However, after a certain input power, output power is converged. Due to such a nonlinear characteristic, an operating point of the power amplifier may vary according to a peak-to-average power ratio (PAPR). A signal having a small PAPR has a small difference between average power and peak power of an input signal, thereby enabling amplification without distortion. However, a signal having a high PAPR may require the power amplifier to operate at a lower operation point in order to amplify up to a peak signal without distortion. In addition, if the PAPR is high, efficiency may decrease due to a nonlinear operation. In an OFDM system, as signals are mapped in subcarrier and symbol basis, there is a problem that the PAPR temporarily increases. As the amount of resources allocated to a frequency domain within a designated symbol interval increases, the PAPR increases, so efficiency may decrease. The controller 850 may control the resistor selection circuit 310 based on resource allocation within a symbol, to improve efficiency of the Doherty power amplifier 300. Based on a control signal of the controller 850, the resistor selection circuit 310 may be configured to select an isolation resistor having one among a plurality of impedances. For example, in a case that the amount of resource allocation within the symbol is greater than an RB threshold value (or an RE threshold value), the controller 850 may control the resistor selection circuit 310 to identify an isolation resistor having an impedance (e.g., about 25 ohms, about $50/\sqrt{2}$ ohms) lower than the reference impedance. In another example, in a case that the amount of resource allocation within the symbol is less than or equal to the RB threshold value (or the RE threshold value), the controller 850 may control the resistor selection circuit 310 to identify an isolation resistor having an impedance (e.g., about $50/\sqrt{2}$ ohms, about 100 ohms) higher than the reference impedance.

According to an embodiment, the controller 850 may control the resistor selection circuit 310 based on temperature. Based on a control signal of the controller 850, the resistor selection circuit 310 may be configured to select an isolation resistor having one among a plurality of impedances. A temperature of a transmitter (e.g., equipment including the Doherty power amplifier 300) may be obtained through a separately provided sensor instead of a traffic load. For example, in a case that the temperature is greater than a threshold value, the controller 850 may control the resistor selection circuit 310 to identify an isolation resistor having an impedance (e.g., about 25 ohms, about $50/\sqrt{2}$ ohms) lower than the reference impedance. In another example, in a case that the temperature is less than or equal to the threshold value, the controller 850 may control the resistor selection circuit 310 to identify an isolation resistor having an impedance (e.g., about $50/\sqrt{2}$ ohms, about 100 ohms) higher than the reference impedance.

According to an embodiment, the controller 850 may control the resistor selection circuit 310 based on a carrier configuration. Based on a control signal of the controller 850, the resistor selection circuit 310 may be configured to select an isolation resistor having one among a plurality of impedances. For example, the base station 110 or the RU 220 may provide a signal to the terminal 120 through carrier aggregation (CA). The CA is a technology for providing a communication service through a plurality of cells, and the plurality of cells may include a primary cell (PCell) and at least one secondary cell (SCell). Each cell may have a center frequency (which may be referred to as a component carrier or a carrier frequency) and a bandwidth. The further a distance between a center frequency of the PCell and a center frequency of the SCell, the more difficult amplification using load modulation becomes. In signal processing for transmission, as a difference between frequencies increases, more current may be consumed for load modulation. The controller 850 may control the resistor selection circuit 310 to reduce the amount of current consumption and achieve high efficiency. For example, in a case that a frequency difference between carrier frequencies is greater than a threshold value, the controller 850 may control the resistor selection circuit 310 to identify an isolation resistor having an impedance (e.g., about 25 ohms, about $50/\sqrt{2}$ ohms) lower than a reference impedance. In another example, in a case that the frequency difference between the carrier frequencies is less than or equal to the threshold value, the controller 850 may control the resistor selection circuit 310 to identify an isolation resistor having an impedance (e.g., about 50√2 ohms, about 100 ohms) higher than the reference impedance.

In FIG. 8B, one antenna is described as an example, but the embodiments of the present disclosure are not limited thereto. As described above with reference to FIG. 2C, one RF path may correspond to a sub-array. Power supplied through one Doherty power amplifier 300 may be distributed respectively to antenna elements of the sub-array.

In FIG. 8B, embodiments in which an impedance of an isolation resistor of the resistor selection circuit 310 is adjusted by a control signal of the controller 850 in various scenarios are described, but the embodiments of the present disclosure do not limit a subject of control to the controller 850.

It may also be understood as an embodiment of the present disclosure that an operator of the base station 110 or the RU 220 mechanically controls the resistor selection circuit 310 to directly select one among a plurality of resistors. To this end, resistors of the resistor selection circuit 310 may be physically disposed within a certain region of a transmission module (e.g., an RF module of the base station 110 or the RU 220) for manual control. A signal line may be provided within a transmission module such that a terminal of a resistor having a specific impedance lower than a reference impedance is connected to a port (e.g., the second port 402) of the coupler 320. It may also be understood as an embodiment of the present disclosure that separate equipment managed by an operator transmits a control signal to the resistor selection circuit 310 or transmits a control message to the controller 850.

FIGS. 9A to 9C illustrate exemplary arrangements of a resistor selection circuit (e.g., the resistor selection circuit 310). In FIGS. 9A to 9C, the resistor selection circuit 310 is designed based on components including individual resistors rather than a digital resistor or a variable resistor controlled by an electrical signal, and arrangements according to such a design are described.

Referring to FIG. 9A, an electronic device (e.g., the base station 110 or the RU 220) may include a plurality of antenna elements (e.g., a first antenna element 901, a second antenna element 902, and a third antenna element 903). The electronic device may include an antenna board 910. The plurality of antenna elements may be disposed on a first side of the antenna board 910. For example, the antenna board 910 may include a printed circuit board (PCB) or a flexible PCB (FPCB). A second side of the antenna board 910, which is different from the first side, may be combined with a first side of the PCB 920 described later. As an example, the antenna board 910 may be referred to as an antenna substrate, a radiation substrate, a radiation board, or an RF board instead of the antenna board.

The electronic device may include the PCB 920. As an example, the PCB 920 may be referred to as an RU board, a main board, a power board, a mother board, a package board, or a filter board. A first side of the PCB 920 may be combined with the antenna board 910. A second side of the PCB 920 opposite to the first side may be combined with a filter 930. The filter 930 may be configured to identify whether a supplied RF signal is a signal of a required frequency band. For example, the filter 930, which is a band pass filter, may be configured to pass a signal of a corresponding frequency band and reduce (or at least partially block) signals outside the corresponding frequency band.

The electronic device may include a power amplifier 940. The power amplifier 940 may be disposed on a first side of the PCB 920. According to an embodiment, the power amplifier 940 may include components of the Doherty power amplifier 300. The power amplifier 940 may include power amplifier circuitry 330 including a carrier amplifier 370a and a peaking amplifier 370b. The power amplifier 940 may include a coupler (e.g., the coupler 320) for distributing powers applied to the carrier amplifier 370a and the peaking amplifier 370b in the Doherty power amplifier 300. For example, the coupler 320 may be configured with four-port. For an isolation resistor connected to an isolation port of the coupler 320, the electronic device may include a resistor selection circuit (e.g., the resistor selection circuit 310). A switching circuit 810 of the resistor selection circuit 310 may be disposed as a component of the power amplifier 940.

The resistor selection circuit 310 may include a plurality of resistors 950. For example, the resistor selection circuit 310 may include a first resistor 960-1 to an Nth resistor 960-N (where N is an integer equal to or greater than 2). The plurality of resistors 950 may be disposed in a region separate from the power amplifier 940. According to an embodiment, the plurality of resistors 950 may be disposed on a second side of the PCB 920. While antenna elements (e.g., the first antenna element 901, the second antenna element 902, and the third antenna element 903) are disposed on the first side of the PCB 920, the second side of the PCB 920 may have relatively more spatial margin. The second surface of the PCB 920 may be utilized for the placement of additional resistors. A signal line may be formed for an electrical connection between the plurality of resistors 950 and the switching circuit 810 (or the power amplifier 940). The PCB 920 may include one or more layers. For example, a conductive via may be formed in the PCB 920 to provide an electrical connection across the plurality of layers of the PCB 920. Through the conductive via, the plurality of resistors 950 may be electrically connected to the power amplifier 940.

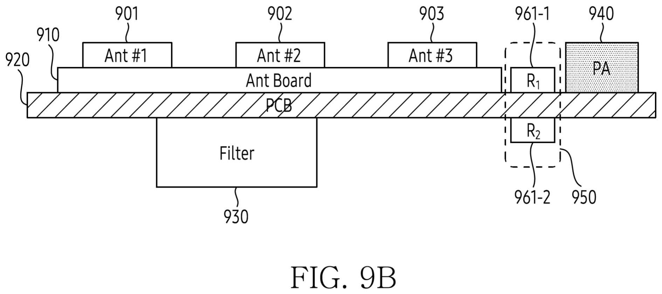

Referring to FIG. 9B, an electronic device (e.g., the base station 110 or the RU 220) may include a plurality of antenna elements (e.g., the first antenna element 901, the second antenna element 902, and the third antenna element 903). The electronic device may include an antenna board 910. The electronic device may include a PCB 920. The electronic device may include a filter 930. The electronic device may include a power amplifier 940. The description for the same reference numerals may be referred to in FIG. 9A. In one embodiment, the power amplifier 940 may include components of the Doherty power amplifier 300. The power amplifier 940 may include a coupler 320 and power amplifier circuitry 330. For an isolation resistor connected to an isolation port of the coupler 320, the electronic device may include a resistor selection circuit (e.g., the resistor selection circuit 310). A switching circuit 810 of the resistor selection circuit 310 may be disposed as a component of the power amplifier 940.

The resistor selection circuit 310 may include a plurality of resistors 950. According to an embodiment, at least a portion of the plurality of resistors 950 may be disposed on a region distinguished from at least another portion of the plurality of resistors 950. For example, at least a portion (e.g., a first resistor 961-1) of the plurality of resistors 950 may be disposed on a first side of the PCB 920, and a remaining portion (e.g., a second resistor 961-2) of the plurality of resistors 950 may be disposed on a second side of the PCB 920. A signal line may be formed for an electrical connection between a resistor (e.g., the second resistor 961-2) disposed in a region separated from the power amplifier 940 and the switching circuit 810 (or the power amplifier 940). The PCB 920 may include one or more layers. For example, a conductive via may be formed in the PCB 920 to provide an electrical connection across the plurality of layers of the PCB 920. Through the conductive via, the second resistor 961-2 may be electrically connected to the power amplifier 940.

FIG. 9B may be utilized to arrange the resistor selection circuit 310 according to embodiments of the present disclosure with respect to an existing electronic device (e.g., the base station 110 or the RU 220). In a general coupler, impedance matching may be performed based on a reference impedance (e.g., about 50 ohms), in a manufacturing process or an assembly process. Since an isolation port of the coupler is matched to the reference impedance, a resistor providing the reference impedance may be disposed in a region of the electronic device. Since another resistor (hereinafter, isolation resistor) is additionally disposed instead of connection with the previously disposed resistor, an impedance lower than the reference impedance may be provided to the isolation port. For example, through a switch, a conductive line connected to the isolation port may electrically connect the previously provided resistor (e.g., a resistor providing an impedance of 50 ohms) and another isolation resistor (e.g., a resistor providing an impedance of 25 ohms) to the coupler (e.g., the coupler 320). In this manner, an embodiment of the present disclosure may be implemented only by adding an additional resistor without disassembling the resistor connected to the existing Doherty power amplifier coupler. As an additional embodiment, since the added resistor is disposed in parallel with the previously provided resistor, a total impedance applied to the isolation port may become lower than the reference impedance.

In FIGS. 9A and 9B, resistors of the resistor selection circuit 310 disposed on the first side and/or the second side of the PCB 920 have been described, but embodiments of the present disclosure are not limited thereto. At least a portion of the plurality of resistors 950 may also be understood as one embodiment of the present disclosure in which the resistors are positioned inside the PCB 920.

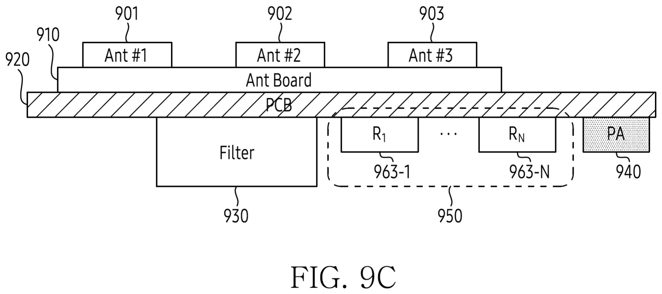

Referring to FIG. 9C, an electronic device (e.g., the base station 110 or the RU 220) may include a plurality of antenna elements (e.g., the first antenna element 901, the second antenna element 902, and the third antenna element 903). The electronic device may include an antenna board 910. The electronic device may include a PCB 920. The electronic device may include a filter 930. The description for the same reference numerals may be referred to in FIG. 9A.

The electronic device may include a power amplifier 940. According to an embodiment, the power amplifier 940 may include components of the Doherty power amplifier 300. The power amplifier 940 may be disposed on the second side of the PCB 920 for space utilization. The power amplifier 940 may include the coupler 320 and the power amplifier circuitry 330. For an isolation resistor connected to an isolation port of the coupler 320, the electronic device may include a resistor selection circuit (e.g., the resistor selection circuit 310). A switching circuit 810 of the resistor selection circuit 310 may be disposed as a component of the power amplifier 940. The resistor selection circuit 310 may include a plurality of resistors 950. The plurality of resistors 950 may be disposed on the second side of the PCB 920. Since both the power amplifier 940 and the plurality of resistors 950 are disposed on the second side of the PCB 920, unlike FIGS. 9A and 9B, a conductive via for connection between layers of the PCB 920 may not be required.

In FIG. 9C, an example in which both the power amplifier 940 and the plurality of resistors 950 are disposed on the second side of the PCB 920 has been described, but embodiments of the present disclosure are not limited thereto. According to an embodiment, at least a portion of the plurality of resistors 950 may be disposed on the first side of the PCB 920. In this case, a conductive via for an electrical connection between layers of the PCB 920 may be disposed.

In FIGS. 9A to 9C, an example in which the antenna board 910 and the PCB 920 are directly coupled have been described, but embodiments of the present disclosure are not limited thereto. According to another embodiment, the antenna board 910 and the PCB 920 may be coupled through a grid array (e.g., a ball grid array (BGA) or a land grid array (LGA)).

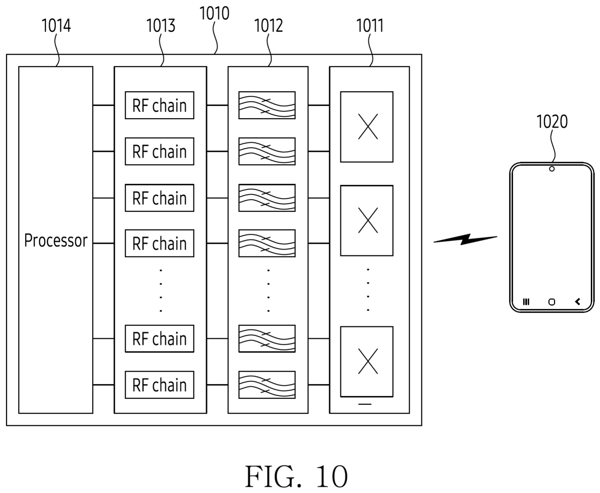

FIG. 10 illustrates an example of a functional configuration of an electronic device. For example, the electronic device 1010 may be one of the base station 110 (or the RU 220) and the terminal 120, and the electronic device 1020 may be another one of the base station 110 (or the RU 220) and the terminal 120. The electronic device 1010 may be an antenna equipment of an RFIC including one or more RF chains. In addition to the power amplifier itself described with reference to FIGS. 1 to 9C, the electronic device including the power amplifier is also included in the embodiments of the present disclosure. The electronic device 1010 may include, as an RF component, a Doherty power amplifier using an impedance lower than a reference impedance (e.g., 50 ohms) used for impedance matching as an isolation resistor.

Referring to FIG. 10, an exemplary functional configuration of an electronic device 1010 is illustrated. The electronic device 1010 may include an antenna unit 1011, a filter unit 1012, a radio frequency (RF) processing unit 1013, and a control unit 1014.

The antenna unit 1011 may include a plurality of antennas. The antennas perform functions for transmitting and receiving signals through a wireless channel. The antennas may include radiators made of conductors or conductive patterns formed on a substrate (e.g., a PCB). The antenna may radiate up-converted signals on a wireless channel or obtain signals radiated by another device. Each antenna may be referred to as an antenna element or an antenna device. According to an embodiment, the antenna unit 1011 may include an antenna array in which a plurality of antenna elements form an array. The antenna unit 1011 may be electrically connected to the filter unit 1012 through RF signal lines. The antenna unit 1011 may be mounted on a PCB including a plurality of antenna elements. The PCB may include a plurality of RF signal lines connecting each antenna element and a filter of the filter unit 1012. Such RF signal lines may be referred to as a feeding network. The antenna unit 1011 may provide a received signal to the filter unit 1012 or radiate a signal provided from the filter unit 1012 into the air.

The filter unit 1012 may perform filtering to transmit a signal of a desired frequency. The filter unit 1012 may perform a function of selectively identifying a frequency by forming resonance. The filter unit 1012 may include at least one of a band pass filter, a low pass filter, a high pass filter, or a band reject filter. That is, the filter unit 1012 may include RF circuits for obtaining a signal of a frequency band for transmission or a frequency band for reception. The filter unit 1012 according to various embodiments may electrically connect the antenna unit 1011 and the RF processing unit 1013.

The RF processing unit 1013 may include a plurality of RF paths. An RF path may be a unit of a path through which a signal received through an antenna or a signal radiated through an antenna passes. At least one RF path may be referred to as an RF chain. The RF chain may include a plurality of RF components. The RF components may include an amplifier, a mixer, an oscillator, a digital-to-analog converter (DAC), and an analog-to-digital converter (ADC). For example, the RF processing unit 1013 may include an upconverter that upconverts a digital transmission signal of a base band into a transmission frequency and a DAC that converts the upconverted digital transmission signal into an analog RF transmission signal. The up converter and the DAC form portion of a transmission path. The transmission path may further include a power amplifier (PA) or a coupler (or combiner). In addition, for example, the RF processing unit 1013 may include an ADC that converts an analog RF reception signal into a digital reception signal and a down converter that converts a digital reception signal into a digital reception signal of a base band. The ADC and the down converter form a portion of a reception path. The reception path may further include a low-noise amplifier (LNA) or a coupler (or divider). The RF components of the RF processing unit may be implemented on a PCB. For example, the base station 1010 may include a stacked structure in the order of the antenna unit 1011, the filter unit 1012, and the RF processing unit 1013. For example, the antennas and the RF components of the RF processing unit may be implemented on a PCB. For example, filters may be repeatedly coupled between PCBs to form a plurality of layers.

The RF processing unit 1013 may include a plurality of RF processing chains for a plurality of signal paths delivered to the antenna unit 1011 and the filter unit 1012. For example, the RF processing unit 1013 may be an RFIC. The RFIC may include a plurality of RF processing chains. A signal applied from a baseband may be inputted to the RFIC. The signal inputted to the RFIC may be distributed to each antenna element. In this case, independent phase shifts may be applied to each of the antenna elements for beamforming. Accordingly, the RFIC may include RF processing chains for processing signals to be delivered to each antenna element. Each RF processing chain may include one or more RF components for RF signal processing. The RF processing unit 1013 may include a Doherty power amplifier using an impedance lower than a reference impedance (e.g., 50 ohms) as an isolation resistor. The Doherty power amplifier may include a resistor selection circuit (e.g., the resistor selection circuit 310) for providing the isolation resistor. The Doherty power amplifier may include a coupler (e.g., the hybrid coupler 320) and power amplifier circuitry (e.g., the power amplifier circuitry 330). The resistor selection circuit may be connected to an isolation port of the coupler of the Doherty power amplifier. The reference impedance indicates a set value for impedance matching of the four ports of the coupler and the power amplifier circuitry. For example, the reference impedance may be 50 ohms.

The control unit 1014 may control overall operations of the electronic device 1010. For example, the control unit 1014 may include the controller 850. The controller 850 may control a switching circuit of the resistor selection circuit. The control unit 1014 may include various modules for performing communication. The control unit 1014 may include at least one processor such as a modem. The control unit 1014 may include modules for digital signal processing. For example, the control unit 1014 may include a modem. When transmitting data, the control unit 1014 may generate complex symbols by encoding and modulating a transmission bit stream. In addition, for example, when receiving data, the control unit 1014 may restore a received bit stream by demodulating and decoding a baseband signal. The control unit 1014 may perform functions of a protocol stack required by a communication standard.

In FIG. 10, a functional configuration of the electronic device 1010 is described as equipment in which the Doherty power amplifier of the present disclosure may be utilized. However, the example illustrated in FIG. 10 is merely an exemplary configuration for utilizing the Doherty power amplifier described through FIGS. 1A to 9C, and the embodiments of the present disclosure are not limited to the components illustrated in FIG. 10. An RF module, an RFIC, other types of communication equipment, or a structure for the Doherty power amplifier including the Doherty power amplifier having the above-described resistor selection circuit may also be understood as embodiments of the present disclosure.

According to embodiments, an electronic device for a Doherty power amplifier is provided. The electronic device may comprise a coupler configured to obtain a radio frequency (RF) input signal. The electronic device may comprise power amplifier circuitry including a carrier amplifier circuit and a peaking amplifier circuit. The electronic device may comprise a resistance selection circuit configured to provide, to the coupler, an isolation impedance among a plurality of impedances. A first port of the coupler may be configured to receive the RF input signal. A second port of the coupler may be configured to be connected to the resistance selection circuit. A third port of the coupler may be configured to be connected to the carrier amplifier circuit. A fourth port of the coupler may be configured to be connected to the peaking amplifier circuit. The first port, the second port, the third port, and the fourth port of the coupler may be matched based on a first impedance. The plurality of impedances may include the first impedance and a second impedance smaller than the first impedance.

According to an embodiment, the resistance selection circuit may be configured to provide, among the plurality of impedances, the isolation impedance based on an input capacitance between the peaking amplifier circuit and the fourth port.

According to an embodiment, power of the RF input signal may be distributed respectively to the carrier amplifier and the peaking amplifier based on the coupler and the resistance selection circuit. A power ratio provided to the carrier amplifier based on the second impedance may be higher than a power ratio provided to the carrier amplifier based on the first impedance.

According to an embodiment, the coupler may comprise a branch-line coupler. The first port may be an input port configured to receive the RF input signal. The second port may be an isolation port for the isolation impedance. The third port may be a first output port configured to provide a first RF signal to the carrier amplifier circuit. The fourth port may be a second output port configured to provide a second RF signal to the peaking amplifier circuit.

According to an embodiment, the coupler may comprise a first transmission line between the first port and the second port, a second transmission line between the second port and the third port, a third transmission line between the third port and the fourth port, and a fourth transmission line between the first port and the fourth port. The first transmission line and the fourth transmission line may provide a first line impedance having a phase difference of 90 degrees. The second transmission line and the third transmission line may provide a second line impedance having a phase difference of 90 degrees. The first line impedance may be $1/\sqrt{2}$ of the second line impedance.

According to an embodiment, the resistance selection circuit may include a plurality of resistors having different impedance values, and a switching circuit configured to connect an identified isolation resistor among the plurality of resistors to the second port.

According to an embodiment, the power amplifier circuit may be disposed on a first side of a printed circuit board (PCB). At least one resistor among the plurality of resistors may be disposed on a second side of the PCB opposite to the first side.

According to an embodiment, the PCB may comprise a plurality of layers. The at least one resistor may be electrically connected to the switching circuit through a via formed across the plurality of layers of the PCB.

According to an embodiment, a first resistor among the plurality of resistors may have the first impedance. A second resistor among the plurality of resistors may have the second impedance.

According to an embodiment, the electronic device may further comprise a controller. The controller may be configured to control the switching circuit to connect one of the plurality of resistors to the second port.

According to an embodiment, the isolation impedance among the plurality of impedances may be identified based on a carrier aggregation (CA) configuration. An isolation impedance identified in a first CA configuration in which a difference between a carrier frequency of a primary cell (PCell) and a carrier frequency of a secondary cell (SCell) is a first value may be greater than an isolation impedance identified in a second CA configuration in which a difference between the carrier frequency of the PCell and the carrier frequency of the SCell is a second value. The first value may be smaller than the second value.

According to an embodiment, the isolation impedance among the plurality of impedances may be identified based on temperature. An isolation impedance identified at a first temperature may be greater than an isolation impedance identified at a second temperature. The first temperature may be lower than the second temperature.

According to an embodiment, the isolation impedance among the plurality of impedances may be identified based on traffic within a specified time. An isolation impedance identified at traffic of a first magnitude may be greater than an isolation impedance identified at traffic of a second magnitude. The first magnitude may be smaller than the second magnitude.

According to embodiments, an electronic device is provided. The electronic device may comprise a plurality of antenna radiators, a plurality of filters for the plurality of antenna radiators, a plurality of Doherty power amplifier circuits for the plurality of antenna radiators, and a processor. A Doherty power amplifier circuit of the plurality of Doherty power amplifier circuits may comprise a coupler configured to obtain a radio frequency (RF) input signal. The Doherty power amplifier circuit may comprise power amplifier circuitry including a carrier amplifier circuit and a peaking amplifier circuit. The Doherty power amplifier circuit may comprise a resistance selection circuit configured to provide, to the coupler, an isolation impedance among a plurality of impedances. A first port of the coupler may be configured to receive the RF input signal. A second port of the coupler may be configured to be connected to the resistance selection circuit. A third port of the coupler may be configured to be connected to the carrier amplifier circuit. A fourth port of the coupler may be configured to be connected to the peaking amplifier circuit. The first port, the second port, the third port, and the fourth port of the coupler may be matched based on a first impedance. The plurality of impedances may include the first impedance and a second impedance smaller than the first impedance.

According to an embodiment, the resistor selection circuit may be configured to provide one of the plurality of impedances based on an input capacitance between the peaking amplifier circuit and the fourth port.

According to an embodiment, power of the RF input signal may be distributed respectively to the carrier amplifier and the peaking amplifier based on the coupler and the resistance selection circuit. A power ratio provided to the carrier amplifier based on the second impedance may be higher than a power ratio provided to the carrier amplifier based on the first impedance.

According to an embodiment, the resistor selection circuit may include a plurality of resistors having different impedance values. The resistor selection circuit may include a switching circuit for connecting one of the plurality of resistors to the second port.

According to an embodiment, the electronic device may further include a printed circuit board (PCB). The plurality of antenna radiators may be disposed on a first side of the PCB. At least one resistor among the plurality of resistors may be disposed on a second side of the PCB opposite to the first side.

According to an embodiment, the PCB may include a plurality of layers. The at least one resistor may be electrically connected to the switching circuit through a via formed across the plurality of layers.

According to an embodiment, the processor may be configured to control the switching circuit to connect one of the plurality of resistors to the second port.

An electronic device according to embodiments of the present disclosure proposes a technique for adaptively adjusting (e.g., changing it to have an impedance lower than a reference impedance) an impedance of an isolation resistor of a power distributor of a Doherty power amplifier. Although a hybrid coupler is illustrated as the above-described distributor, embodiments of the present disclosure are not limited thereto. The hybrid coupler is merely an example of a component for dividing power equally (e.g., at a 1:1 ratio), and unlike 3 dB, the isolation resistor according to the present disclosure may also be disposed in a distributor that distributes power applied to a carrier amplifier and power applied to a peaking amplifier at a different ratio (e.g., 2 dB or 5 dB). As the isolation resistor is disposed at an isolation port of the power distributor, amplifier efficiency may be improved at a specific power level. In addition, the added resistor may be a passive element less sensitive to an operating frequency, unlike an inductor or a capacitor. Therefore, as the frequency band and/or cell of the electronic device (e.g., the base station 110 or the RU 220) are expanded in the future, a required range of amplifier efficiency may become wider. In this case, without separate tuning according to frequency, the power amplifier may provide the required amplifier efficiency through adjustment of the isolation impedance.

The Doherty power amplifier according to embodiments of the present disclosure proposes a scheme for lowering the impedance of an isolation port below a reference impedance to provide improved efficiency and a wide operating range, unlike controlling components to improve linearity. In a low output range (e.g., a first power level region), the power distribution ratio of power provided to each of a carrier amplifier and a peaking amplifier may be adjusted for efficiency improvement. By adaptively selecting a resistor having an impedance lower than the reference impedance used for impedance matching, efficiency improvement may be achieved. In addition, the Doherty power amplifier according to the embodiments may provide an amplifier mode more suitable for a current communication state (e.g., temperature, traffic, or carrier configuration) by utilizing a trade-off relationship between efficiency improvement and gain.

The effects that can be obtained from the present disclosure are not limited to those described above, and any other effects not mentioned herein will be clearly understood by those having ordinary knowledge in the art to which the present disclosure belongs, from the following description.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

**Claims**

1. An electronic device for a Doherty power amplifier, comprising:

   a coupler configured to obtain a radio frequency (RF) input signal;
   power amplifier circuitry including a carrier amplifier circuit and a peaking amplifier circuit; and
   a resistance selection circuit configured to provide, to the coupler, an isolation impedance among a plurality of impedances,
   wherein a first port of the coupler is configured to receive the RF input signal,
   wherein a second port of the coupler is configured to be connected to the resistance selection circuit,
   wherein a third port of the coupler is configured to be connected to the carrier amplifier circuit,
   wherein a fourth port of the coupler is configured to be connected to the peaking amplifier circuit,
   wherein the first port, the second port, the third port, and the fourth port of the coupler are matched based on a first impedance, and
   wherein the plurality of impedances include the first impedance and a second impedance smaller than the first impedance.

2. The electronic device of claim 1,
   wherein the resistance selection circuit is configured to provide, among the plurality of impedances, the isolation impedance based on an input capacitance between the peaking amplifier circuit and the fourth port.

3. The electronic device of claim 1,

   wherein power of the RF input signal is distributed respectively to the carrier amplifier and the peaking amplifier based on the coupler and the resistance selection circuit, and
   wherein a power ratio provided to the carrier amplifier based on the second impedance is higher than a power ratio provided to the carrier amplifier based on the first impedance.

4. The electronic device of claim 1,

   wherein the coupler comprises a branch-line coupler,
   wherein the first port is an input port configured to receive the RF input signal,
   wherein the second port is an isolation port for the isolation impedance,
   wherein the third port is a first output port configured to provide a first RF signal to the carrier amplifier circuit, and
   wherein the fourth port is a second output port configured to provide a second RF signal to the peaking amplifier circuit.

5. The electronic device of claim 4,
wherein the coupler comprises:

a first transmission line between the first port and the second port,
a second transmission line between the second port and the third port,
a third transmission line between the third port and the fourth port, and
a fourth transmission line between the first port and the fourth port, and
wherein the first transmission line and the fourth transmission line provide a first line impedance having a phase difference of 90 degrees,
wherein the second transmission line and the third transmission line provide a second line impedance having a phase difference of 90 degrees, and
wherein the first line impedance is $1/\sqrt{2}$ of the second line impedance.

6. The electronic device of claim 1,
wherein the resistance selection circuit includes:

a plurality of resistors having different impedance values; and
a switching circuit configured to connect an identified isolation resistor among the plurality of resistors to the second port.

7. The electronic device of claim 6,

wherein the power amplifier circuit is disposed on a first side of a printed circuit board (PCB), and
wherein at least one resistor among the plurality of resistors is disposed on a second side of the PCB opposite to the first side.

8. The electronic device of claim 7,

wherein the PCB comprises a plurality of layers, and
wherein the at least one resistor is electrically connected to the switching circuit through a via formed across the plurality of layers of the PCB.

9. The electronic device of claim 7,

wherein a first resistor among the plurality of resistors has the first impedance, and
wherein a second resistor among the plurality of resistors has the second impedance.

10. The electronic device of claim 7, further comprising a controller,
wherein the controller is configured to control the switching circuit to connect one of the plurality of resistors to the second port.

11. The electronic device of claim 1,

wherein the isolation impedance among the plurality of impedances is identified based on a carrier aggregation (CA) configuration,
wherein an isolation impedance identified in a first CA configuration in which a difference between a carrier frequency of a primary cell (PCell) and a carrier frequency of a secondary cell (SCell) is a first value is greater than an isolation impedance identified in a second CA configuration in which a difference between the carrier frequency of the PCell and the carrier frequency of the SCell is a second value, and
wherein the first value is smaller than the second value.

12. The electronic device of claim 1,

wherein the isolation impedance among the plurality of impedances is identified based on temperature,
wherein an isolation impedance identified at a first temperature is greater than an isolation impedance identified at a second temperature, and
wherein the first temperature is lower than the second temperature.

13. The electronic device of claim 1,

wherein the isolation impedance among the plurality of impedances is identified based on traffic within a specified time,
wherein an isolation impedance identified at traffic of a first magnitude is greater than an isolation impedance identified at traffic of a second magnitude, and
wherein the first magnitude is smaller than the second magnitude.

14. An electronic device, comprising:

a plurality of antenna radiators;
a plurality of filters for the plurality of antenna radiators;
a plurality of Doherty power amplifier circuits for the plurality of antenna radiators; and
a processor,
wherein a Doherty power amplifier circuit of the plurality of Doherty power amplifier circuits comprises:

a coupler configured to obtain a radio frequency (RF) input signal,

power amplifier circuitry including a carrier amplifier circuit and a peaking amplifier circuit, and

a resistance selection circuit configured to provide, to the coupler, an isolation impedance among a plurality of impedances,

wherein a first port of the coupler is configured to receive the RF input signal,

wherein a second port of the coupler is configured to be connected to the resistance selection circuit,

wherein a third port of the coupler is configured to be connected to the carrier amplifier circuit,

wherein a fourth port of the coupler is configured to be connected to the peaking amplifier circuit,

wherein the first port, the second port, the third port, and the fourth port of the coupler are matched based on a first impedance, and

wherein the plurality of impedances include the first impedance and a second impedance smaller than the first impedance.

15. The electronic device of claim 14, further comprising a printed circuit board (PCB),

wherein the resistance selection circuit comprises a plurality of resistors having different impedance values and a switching circuit configured to connect one of the plurality of resistors to the second port,

wherein the plurality of antenna radiators are disposed on a first side of the PCB,

wherein at least one resistor among the plurality of resistors is disposed on a second side of the PCB opposite to the first side, and

wherein the at least one resistor is electrically connected to the switching circuit through a via formed across a plurality of layers of the PCB.

FIG. 1

110

210

215

220

DU

RU

FIG. 2A

FIG. 2B

251-1

252-1

253-1

240-1

DOHERTY PA

DAC 230-1

251-2

252-2

253-2

240-2

DOHERTY PA

DAC 230-2

251-N

252-N

253-N

240-N

DOHERTY PA

DAC 230-N

FIG. 2C

FIG. 3A

FIG. 3B

FIG. 4

500

FIG. 5A

FIG. 5B

FIG. 6

FIG. 7A

FIG. 7B

FIG. 8A

EP 4 708 675 A1

FIG. 8B

FIG. 9A

FIG. 9B

FIG. 9C

FIG. 10

## INTERNATIONAL SEARCH REPORT

| International application No. |
|---|
| **PCT/KR2024/003051** |

**A. CLASSIFICATION OF SUBJECT MATTER**

**H03F 1/02**(2006.01)i; **H03F 1/56**(2006.01)i; **H03F 3/21**(2006.01)i; **H03F 3/60**(2006.01)i

According to International Patent Classification (IPC) or to both national classification and IPC

**B. FIELDS SEARCHED**

Minimum documentation searched (classification system followed by classification symbols)

H03F 1/02(2006.01); H01P 5/22(2006.01); H01Q 1/24(2006.01); H01Q 1/38(2006.01); H03F 1/07(2006.01); H03F 1/32(2006.01); H03F 1/42(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 도허티 증폭기(doherty amplifier), 격리 임피던스(isolation impedance), 커플러 (coupler), 캐리어 증폭기(carrier amplifier), 피킹 증폭기(peaking amplifier)

**C. DOCUMENTS CONSIDERED TO BE RELEVANT**

| Category* | Citation of document, with indication, where appropriate, of the relevant passages | Relevant to claim No. |
|---|---|---|
| | US 2017-0019071 A1 (QORVO US, INC.) 19 January 2017 (2017-01-19) | |
| X | See paragraphs [0074]-[0123]; and figure 7. | 1,4,6,14 |
| Y | | 2,5,7-10,15 |
| A | | 3,11-13 |
| | KR 10-1672797 B1 (KOREA ADVANCED INSTITUTE OF SCIENCE AND TECHNOLOGY et al.) 08 November 2016 (2016-11-08) | |
| Y | See paragraph [0028]; and figures 13-14. | 2 |
| | KR 10-0893683 B1 (KOREA ELECTRONICS TECHNOLOGY INSTITUTE) 17 April 2009 (2009-04-17) | |
| Y | See paragraphs [0007]-[0012]; and figure 1. | 5 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 June 2024** | **21 June 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/003051**

| C. | DOCUMENTS CONSIDERED TO BE RELEVANT | |
|---|---|---|
| Category* | Citation of document, with indication, where appropriate, of the relevant passages | Relevant to claim No. |
| Y | KR 10-2010-0051824 A (SONY ERICSSON MOBILE COMMUNICATIONS AB) 18 May 2010 (2010-05-18)<br>See paragraphs [0006]-[0050]; and figure 12. | 7-10,15 |
| A | KR 10-1934933 B1 (SOONCHUNHYANG UNIVERSITY INDUSTRY ACADEMY COOPERATION FOUNDATION) 04 January 2019 (2019-01-04)<br>See paragraphs [0030]-[0051]; and figures 2-3. | 1-15 |

Form PCT/ISA/210 (second sheet) (July 2022)

**INTERNATIONAL SEARCH REPORT**
Information on patent family members

International application No.

**PCT/KR2024/003051**

| Patent document cited in search report | | | Publication date (day/month/year) | Patent family member(s) | | | Publication date (day/month/year) |
|---|---|---|---|---|---|---|---|
| US | 2017-0019071 | A1 | 19 January 2017 | US | 2015-0091653 | A1 | 02 April 2015 |
| | | | | US | 2017-0019072 | A1 | 19 January 2017 |
| | | | | US | 9484865 | B2 | 01 November 2016 |
| | | | | US | 9887671 | B2 | 06 February 2018 |
| | | | | US | 9948243 | B2 | 17 April 2018 |
| KR | 10-1672797 | B1 | 08 November 2016 | KR | 10-2015-0108255 | A | 25 September 2015 |
| KR | 10-0893683 | B1 | 17 April 2009 | | None | | |
| KR | 10-2010-0051824 | A | 18 May 2010 | CN | 101755364 | A | 23 June 2010 |
| | | | | CN | 101755364 | B | 03 April 2013 |
| | | | | EP | 2171795 | A1 | 07 April 2010 |
| | | | | JP | 2010-534445 | A | 04 November 2010 |
| | | | | JP | 5006447 | B2 | 22 August 2012 |
| | | | | US | 2009-0027278 | A1 | 29 January 2009 |
| | | | | US | 7724193 | B2 | 25 May 2010 |
| | | | | WO | 2009-014554 | A1 | 29 January 2009 |
| KR | 10-1934933 | B1 | 04 January 2019 | CN | 111133676 | A | 08 May 2020 |
| | | | | CN | 111133676 | B | 28 March 2023 |
| | | | | US | 11201592 | B2 | 14 December 2021 |
| | | | | US | 2020-0228065 | A1 | 16 July 2020 |
| | | | | WO | 2019-039650 | A1 | 28 February 2019 |

Form PCT/ISA/210 (patent family annex) (July 2022)